# EUROPÄISCHE PATENTSCHRIFT

(11) **EP 3 449 528 B1**
(45) Veröffentlichungstag und Bekanntmachung des Hinweises auf die Patenterteilung: **14.09.2022**
(21) Anmeldenummer: 17729775.1
(22) Anmeldetag: 06.06.2017
(51) Int. Cl.: H01P 5/10, H01P 5/08, H01P 5/12, H01Q 1/24, H01Q 1/38, H01Q 9/06, H01Q 13/10, H01Q 21/08, H05K 1/02, H05K 1/11

(54) **LEITERPLATTENANORDNUNG ZUR SIGNALVERSORGUNG VON STRAHLERN**
CIRCUIT BOARD ASSEMBLY FOR SUPPLYING SIGNALS TO RADIATORS
ENSEMBLE CARTE DE CIRCUIT IMPRIMÉ SERVANT À FOURNIR DES SIGNAUX AUX ÉLÉMENTS RAYONNANT

(30) Priorität: 06.06.2016 DE 102016007052
(43) Veröffentlichungstag der Anmeldung: 06.03.2019
(73) Patentinhaber: Telefonaktiebolaget LM Ericsson (PUBL), 164 83 Stockholm (SE)
(72) Erfinder: VOLLMER, Andreas, 83022 Rosenheim (DE); FLEANCU, Dan, 83556 Griesstätt (DE)
(74) Vertreter: Ericsson
(86) Internationale Anmeldenummer: PCT/EP2017/000656
(87) Internationale Veröffentlichungsnummer: WO 2017/211451

(56) Entgegenhaltungen:
- EP-A1- 2 262 058
- DE-A1-102012 201 282
- RU-U1- 15 150
- US-A- 4 494 083
- US-A1- 2004 027 308
- US-A1- 2009 009 399
- US-A1- 2015 319 860
- SHENG YE ET AL: "High-Gain Planar Antenna Arrays for Mobile Satellite Communications [Antenna Applications Corner]", IEEE ANTENNAS AND PROPAGATION MAGAZINE, IEEE SERVICE CENTER, PISCATAWAY, NJ, US, vol. 54, no. 6, 1 December 2012 (2012-12-01), pages 256-268, XP011494274, ISSN: 1045-9243, DOI: 10.1109/MAP.2012.6387841

## Beschreibung

Die vorliegende Erfindung betrifft eine Leiterplattenanordung mit einer Leiterplatte, deren Metallisierung mindestens eine Koplanar-Streifenleitung zur Signalversorgung eines Strahlers umfasst. Weiterhin betrifft die vorliegende Erfindung eine Leiterplattenanordung mit einer Leiterplatte, deren Metallisierung in mindestens einer ersten Metallisierungsebene einen Strahler umfasst. Insbesondere handelt es sich bei dem Strahler jeweils um einen Mobilfunkstrahler.

In einer möglichen Anwendung betrifft die vorliegende Erfindung insbesondere eine Leiterplattenanordung, bei welcher der Strahler durch die Metallisierung der Leiterplatte der Leiterplattenanordnung gebildet wird, so dass es sich bei dem Strahler um einen Leiterplattenstrahler handelt. Im Bereich des Mobilfunks ist es bekannt, Leiterplattenstrahler einzusetzen. Bei solchen Leiterplattenstrahlern werden üblicherweise sowohl die Signalleitungen, welche den Strahler mit Mobilfunksignalen versorgen, als auch der Strahler selbst durch Abschnitte der Metallisierung der Leiterplatte gebildet. Als Signalleitungen werden dabei in den meisten Fällen Mikrostreifenleitungen eingesetzt.

Der Artikel "In-phase and anti-phase power dividers for UWB differentially fed antenna arrays", Mario Leib et al., IEEE antennas and wireless propagation letters, volume 9, 2010, Seite 455 beschreibt eine Leiterplattenanordung zum Einsatz im Bereich der Radartechnik. Dort werden Koplanar-Streifenleitungen eingesetzt, um zwei Leiterplattenstrahler mit Signalen zu versorgen. Weiterhin weist die Leiterplattenanordnung einen Leistungsteiler auf, welcher durch den Übergang zwischen einer Mikrostreifenleitung und den Koplanar-Streifenleitungen gebildet wird und zwei Leiterplattenantennen parallel mit Signalen der Mikrostreifenleitung versorgt.

Druckschrift US 2015/0319860 A1 zeigt eine Leiterplattenanordnung mit den gegenständlichen Merkmalen der Oberbegriffe der Ansprüche 1 und 6.

Druckschrift DE 10 2012 201282 A1 zeigt eine Leiterplattenanordnung, bei welcher die Strahler eines Antennenarrays durch die Metallisierung der Leiterplattenanordnung gebildet werden.

Druckschrift US 4 494 083 A zeigt eine Mikrostreifenleitung, welche mittels eines Koaxialleitungsabschnitts durch die Schicht einer Leiterplattenanordnung geführt ist.

Druckschrift US 2004/027308 A1 zeigt eine Spiralantenne, welche durch die Metallisierung einer Leiterplatte gebildet wird und durch ein Koaxialkabel gespeist wird.

Druckschrift EP 2 262 058 A1 offenbart eine Antennenanordnung auf einer Leiterplatte, bei der zwei Dipol-Antennen von je einer koplanaren Streifenleitung gespeist werden, wobei zusätzlich ein Balun-Kabel vorgesehen ist.

Aufgabe der vorliegenden Erfindung ist, eine verbesserte Leiterplattenanordnung zur Verfügung zu stellen.

Diese Aufgabe wird erfindungsgemäß durch die Leiterplattenanordnungen gemäß Anspruch 1 gelöst. Bevorzugte Ausgestaltung der vorliegenden Erfindung sind Gegenstand der Unteransprüche.

Die vorliegende Erfindung umfasst eine Leiterplattenanordnung mit einer Leiterplatte, deren Metallisierung mindestens eine Koplanar-Streifenleitung zur Signalversorgung eines Strahlers umfasst. Erfindungsgemäß weist die Leiterplatte einen Feldwandler auf, welcher elektrisch mit der Koplanar-Streifenleitung in Verbindung steht und ein Koaxial-Feld durch mindestens eine Schicht der Leiterplatte hindurch führt und in das Koplanar-Streifenleitungsfeld der Koplanar-Streifenleitung umwandelt. Der erfindungsgemäße Feldwandler erlaubt einen äußerst kompakten Aufbau der Leiterplattenanordnung und erweitert deren Einsatzmöglichkeiten.

Eine solche Leiterplattenanordnung kann insbesondere im Bereich des Mobilfunks eingesetzt werden, so dass es sich bei dem durch die Koplanar-Streifenleitung der Leiterplattenanordnung versorgten Strahler um ein Mobilfunkstrahler handelt. In möglichen Anwendungen der vorliegenden Erfindung kann der Strahler als Antenne einer Basisstation eingesetzt werden. Alternativ ist jedoch auch denkbar, den Strahler als Antenne eines Repeaters oder als Antenne eines Mobilfunkendgerätes, insbesondere als Antenne eines Mobiltelefons, einzusetzen.

Der Feldwandler führt das Koaxialfeld bevorzugt zumindest durch eine dielektrische Schicht der Leiterplatte. In einer möglichen Ausführungsform kann der Feldwandler das Koaxialfeld alternativ oder zusätzlich durch eine Metallisierungsebene der Leiterplatte führen. Besonders bevorzugt führt der Feldwandler das Koaxialfeld zumindest durch eine Metallisierungsebene und zwei angrenzende dielektrische Schichten der Leiterplatte.

Bevorzugt führt Feldwandler das Koaxialfeld senkrecht zur Erstreckung der Leiterplatte durch die mindestens eine Schicht der Leiterplatte.

Die erfindungsgemäß eingesetzten Koplanar-Streifenleitungen werden bevorzugt durch zwei in einer Metallisierungsebene ausgebildete, durch einen Schlitz voneinander getrennte Leitungsbahnen der Leiterplattenanordnung gebildet. Bei dem Koplanar-Streifenleitungsfeld handelt es sich dabei um ein differentielles durch die beiden Leitungsbahnen übertragenes Leitungsfeld.

In einer ersten Ausführungsform ist die Leiterplatte im Bereich der Leitungsbahnen in anderen Ebenen frei von einer Metallisierung. In einer zweiten Ausführungsform kann sich jedoch unterhalb der die Koplanar-Streifenleitung bilden Leitungsbahnen eine Masseebene, welche beispielsweise durch eine weitere Metallisierungsebene der Leiterplattenanordnung gebildet wird, befinden. Solche Ausgestaltungen werden teilweise auch als eine Quasi-Koplanar-Streifenleitung bezeichnet, und bilden ebenfalls eine Koplanar-Streifenleitung im Sinne der vorliegenden Erfindung.

Gemäß der vorliegenden Erfindung bildet der erfindungsgemäße Feldwandler einen Leistungsteiler zur elektrischen Anbindung zweier Strahler an eine Signalleitung. Der Feldwandler hat daher nicht nur die Funktion, das Koaxialfeld durch die Leiterplatte hindurch zu führen und in ein Koplanar-Streifenleitungsfeld umzuwandeln, sondern gleichzeitig die Funktion, zwei Strahler parallel anzubinden. Solche zwei parallel angebundenen Strahler werden teilweise auch als "Doppelblock" bezeichnet.

Erfindungsgemäß weist die Leiterplatte hierfür mindestens zwei Koplanar-Streifenleitungen zur elektrischen Anbindung jeweils eines Strahlers auf, wobei der Feldwandler elektrisch mit beiden Koplanar-Streifenleitungen in Verbindung steht und ein Koaxialfeld durch mindestens eine Schicht der Leiterplatte hindurch führt und die Koplanar-Streifenleitungsfelder der beiden Koplanar-Streifenleitungen umwandelt und aufteilt. Die beiden Koplanar-Streifenleitungen sind bevorzugt in der selben Metallisierungsebene der Leiterplatte ausgebildet.

Die beiden Strahler sind bevorzugt parallel zueinander angeordnet und so an den Feldwandler angebunden, dass die Strahler gleichphasig abstrahlen. Dies erlaubt einen parallelen Betrieb der beiden Strahler und eine konstruktive Überlagerung der Antennendiagramme der beiden Strahler.

In einer ersten Variante der vorliegenden Erfindung kann der Feldwandler das Koaxialfeld in zwei gegenphasige Koplanar-Streifenleitungsfelder umwandeln und aufteilen. Bevorzugt ist in diesem Fall vorgesehen, dass die beiden Koplanar-Streifenleitungen durch unterschiedliche Richtungswechsel ein gleichphasiges Feld an den Strahlern erzeugen. Insbesondere erlaubt dies ein gleichphasiges Abstrahlen der beiden Strahler.

In einer zweiten nicht beanspruchten Variante kann der Feldwandler das Koaxialfeld in zwei gleichphasige Koplanar-Streifenleitungsfelder umwandeln und aufteilen. Bevorzugt erzeugen in diesem Fall die beiden Koplanar-Streifenleitungen durch keine oder identische Richtungswechsel ein gleichphasiges Feld an den Strahlern. Auch hierdurch ist ein gleichphasiges Abstrahlen durch die beiden Strahler möglich.

In einer möglichen Ausführungsform der vorliegenden Erfindung kann der Strahler bzw. können die Strahler bezüglich der Leiterplatte separate Elemente bilden, und beispielsweise auf die Leiterplatte aufgesetzt sein. In diesem Fall sorgt die Leiterplatte lediglich für die Signalleitung zu den Strahlern.

In einer bevorzugten Ausführungsform der vorliegenden Erfindung ist der oder sind die Strahler durch eine Metallisierung der Leiterplatte gebildet. Dies erlaubt eine besonders kompakte Ausgestaltung der Leiterplattenanordnung, bei welcher sowohl die Koplanar-Streifenleitungen, als auch die Strahler durch eine Metallisierung der Leiterplatte gebildet werden.

In einer möglichen Ausführungsform können die Koplanar-Streifenleitungen und der oder die Strahler in unterschiedlichen Ebenen der Leiterplatte verlaufen und insbesondere durch unterschiedliche Metallisierungsebenen gebildet werden.

In einer bevorzugten Ausgestaltung der vorliegenden Erfindung sind der oder die Strahler in der gleichen Ebene der Leiterplatte angeordnet wie die Koplanar-Streifenleitungen, und/oder sind in der gleichen Metallisierungsebene der Leiterplatte ausgebildet.

In einer bevorzugten Ausgestaltung der vorliegenden Erfindung umfasst der Feldwandler Vias und/oder Metallisierungsabschnitte der Leiterplatte. Insbesondere erlauben die Vias dabei, das Koaxialfeld durch mindestens eine Schicht der Leiterplatte hindurch zu leiten. Die Metallisierungsabschnitte der Leiterplatte sorgen bevorzugt für die Feldwandlung und/oder Anbindung an die Koplanar-Streifenleitung.

In einer möglichen Ausführungsform der vorliegenden Erfindung ist der Feldwandler durch Vias und/oder Metallisierungsabschnitte der Leiterplatte gebildet. Insbesondere kann in einer solchen Ausführungsform der Feldwandler komplett in die Leiterplatte integriert und/oder durch Bestandteile der Leiterplatte gebildet sein.

In einer alternativen Ausführungsform kann der Feldwandler jedoch neben Metallisierungsabschnitten der Leiterplatte auch das Ende eines Koaxialkabels umfassen. Das Ende des Koaxialkabels kann entweder zusätzlich zu den Vias, oder anstelle der Vias eingesetzt werden.

In einer Ausführungsform der vorliegenden Erfindung umfasst der Feldwandler einen Koaxialleitungsabschnitt, welcher das Koaxialfeld durch mindestens eine Schicht der Leiterplatte hindurch führt, und einen Koplanar-Umwandlungsabschnitt.

Der Koaxialleitungsabschnitt ist bevorzugt auf die Ebene des Koplanar-Umwandlungsabschnitts des Feldwandlers geführt und/oder ist mit dem Koaxialleitungsabschnitt elektrisch kontaktiert. Durch das Zusammenwirken des Koaxialleitungsabschnitts und des Koplanar-Umwandlungsabschnitts wird das durch die mindestens eine Schicht der Leiterplatte hindurch geführte Koaxialfeld in ein Koplanar-Leitungsfeld umgewandelt. Die elektrische Kontaktierung zwischen den beiden Abschnitten kann galvanisch und/oder kapazitiv erfolgen.

Bevorzugt ist der Koplanar-Umwandlungsabschnitt des Feldwandlers durch Metallisierungsabschnitte der Leiterplatte gebildet. Insbesondere kann der Koplanar-Umwandlungsabschnitt in mindestens eine Koplanar-Streifenleitung übergehen, und ist bevorzugt in der gleichen Metallisierungsebene der Leiterplatte gebildet wie die Koplanar-Streifenleitung bzw. die Koplanar-Streifenleitungen.

In einer möglichen Ausführungsform können mehrere Vias vorgesehen sein, welche einen Außenleiter des Koaxial-Leitungsabschnitts des Feldwandlers bilden. Die Vias sind bevorzugt elektrisch mit dem Koplanar-Umwandlungsabschnitt kontaktiert. Die elektrische Verbindung kann galvanisch und/oder kapazitiv erfolgen.

Alternativ oder zusätzlich kann der Innenleiter des Koaxial-Leitungsabschnitts durch den Innenleiter eines Koaxial-Kabels oder ein Via gebildet werden. Ist der Feldwandler komplett in die Leiterplatte integriert, wird bevorzugt ein Via eingesetzt. Dient der Feldwandler gleichzeitig zum Anschluss eines Koaxialkabels, so wird der Innenleiter des Koaxial-Leitungsabschnitts bevorzugt entweder durch den Innenleiter des Koaxialkabels gebildet, oder durch eine Kombination aus dem Innenleiter des Koaxialkabels und einem Via, indem z.B. der Innenleiter des Koaxialkabels in eine Bohrung des Vias eingeführt und/oder durch das Via hindurchgeführt wird.

In einer Ausführungsform der vorliegenden Erfindung weist der Koplanar-Umwandlungsabschnitt des Feldwandlers zwei Außenleitungsbahnen auf, welche mit dem Außenleiter des Koaxial-Leitungsabschnitts des Feldwandlers in bezüglich des Innenleiters gegenüberliegenden Bereichen in Verbindung stehen. Die beiden Außenleitungsbahnen gehen in jeweils mindestens eine Bahn einer Koplanar-Streifenleitung über.

Weist die Leiterplatte zwei Koplanar-Streifenleitungen auf, so stehen die beiden Koplanar-Streifenleitungen bevorzugt auf entgegengesetzten Seiten mit dem Koplanar-Umwandlungsabschnitt des Feldwandlers in Verbindung. Weiterhin kann mindestens eine Leitungsbahn der jeweiligen Koplanar-Streifenleitung in eine Außenleitungsbahn des Feldwandlers übergehen.

In einer ersten Ausführungsform kann der Koplanar-Umwandlungsabschnitt des Feldwandlers eine Diagonalbahn aufweisen, welche gegenüberliegende Leitungsbahnen der beiden Koplanar-Streifenleitungen diagonal miteinander verbindet. Bevorzugt steht die Diagonalbahn mit dem Innenleiter des Koaxial-Leitungsabschnitts des Feldwandlers in Verbindung. Die Diagonalbahn sorgt hierdurch für eine Aufteilung des Koaxialfeldes in zwei gegenphasige Koplanar-Streifenleitungsfelder. Bevorzugt koppeln die Außenleitungsbahnen auf gegenüberliegenden Seiten kapazitiv oder galvanisch an den Diagonalleitungsabschnitt. Durch diese Kopplung ergibt sich eine Feldtrennung, durch welche das Koaxialfeld in die jeweilige Koplanar-Streifenleitung übergeführt wird.

In einer zweiten Ausführungsform ist vorgesehen, dass die zwei Außenleitungsbahnen jeweils auf ihren beiden Seiten in eine Leitungsbahn der jeweiligen Koplanar-Streifenleitung übergehen. Insbesondere können in diesem Fall die Leitungsbahnen der beiden Koplanar-Streifenleitungen im Bereich des Feldwandlers durch die beiden Außenleitungsbahnen miteinander in Verbindung stehen.

Die Außenleitungsbahnen können dabei eine Aufweitung der Koplanar-Streifenleitung bilden, welche um den Bereich des Innenleiters des Koaxialleitungsabschnitts herum geführt sind. Bevorzugt steht der Innenleiter des Koaxial-Leitungsabschnitts des Feldwandlers nicht mit einem Metallisierungsabschnitt der Koplanar-Streifenleitungen in Verbindung. Bei dieser nicht beanspruchten Ausführungsform erfolgt eine gleichphasige Aufteilung des Koaxialfelds in zwei Koplanar-Streifenleitungsfelder.

Bevorzugt ist vorgesehen, dass die beiden Außenleitungsbahnen in jeweils eine Bahn der Koplanar-Streifenleitung übergehen und auf der gegenüberliegenden Seite miteinander in Verbindung stehen. Die beiden Außenleitungsbahnen bilden damit einen Kurzschluss der beiden Bahnen der Koplanar-Streifenleitungen. Bevorzugt umfasst der Koplanar-Umwandlungsabschnitt des Feldwandlers weiterhin eine Abschlussfläche, welche einen der Außenleiterabschnitte mit dem Innenleiter verbindet. Hierdurch wird das Koaxialfeld in diesem Bereich blockiert, und als Koplanar-Streifenleitungsfeld in die Koplanar-Streifenleitung überführt.

Unabhängig von der konkreten Ausgestaltung ist bevorzugt vorgesehen, dass der zwischen den beiden Leitungsbahnen einer Koplanar-Streifenleitung vorgesehene Schlitz in den Bereich des Koplanar-Umwandlungsabschnitt hinein verlängert ist. Insbesondere verläuft der Schlitz dabei in einen Bereich des Koplanar-Umwandlungsabschnitt hinein, welcher in der Projektion zwischen dem Innenleiter und dem Außenleiter des Koaxial-Leitungsabschnitts des Feldwandlers liegt. Bevorzugt verläuft der Schlitz eine gewisse Strecke um den Innenleiter herum. Bevorzugt ist der Schlitz im Bereich des Koplanar-Umwandlungsabschnitts teilweise um den Innenleiter herum auf einer gekrümmten Bahn geführt. Der Schlitz kann im Bereich des Koplanar-Umwandlungsabschnitts eine größere Breite aufweisen als im Bereich der Koplanar-Streifenleitung.

In einer ersten Ausführungsform der vorliegenden Erfindung dient der Feldwandler gleichzeitig als Anschluss für ein Koaxialkabel. Insbesondere kann das Koaxialkabel quer zur Ebene der Leiterplatte und insbesondere senkrecht zur Ebene der Leiterplatte an diese angeschlossen sein. Bevorzugt wird das Koaxialfeld durch das Koaxialkabel zum Feldwandler geführt.

Bevorzugt bildet in einer solchen Ausführungsform der Innenleiter des Koaxialkabels den Innenleiter des Koaxial-Leitungsabschnitts des Feldwandlers oder ist mit diesem elektrisch kontaktiert. Insbesondere kann der Innenleiter zur Ebene des Koplanar-Umwandlungsabschnittes des Feldwandlers geführt sein und/oder elektrisch mit diesem kontaktiert sein.

Bevorzugt kann der Außenleiter des Koaxialkabels den Außenleiter des Koaxial-Leitungsabschnitts des Feldwandlers bilden, oder mit einem elektrisch kontaktiert sein.

In einer möglichen Ausführungsform kann der Innenleiter des Koaxialkabels durch mindestens eine Schicht der Leiterplatte hindurch auf die Ebene des Koplanar-Umwandlungsabschnitts des Feldwandlers geführt sein und/oder mit diesem elektrisch kontaktiert sein.

Alternativ oder zusätzlich kann der Außenleiter des Koaxialkabels mit einem oder mehreren Vias, welche eine Außenleiter des Koaxial-Leitungsabschnitts des Feldwandlers bilden, elektrisch kontaktiert sein. Alternativ kann jedoch auch auf Vias verzichtet werden, und der Außenleiter des Koaxialkabels durch mindestens eine Schicht der Leiterplatte hindurch auf die Ebene des Koplanar-Umwandlungsabschnitts des Feldwandlers geführt sein, und/oder mit diesem elektrisch kontaktiert sein. Die elektrische Kontaktierung kann galvanisch oder kapazitiv erfolgen.

In einer alternativen Ausführungsform der erfindungsgemäßen Leiterplattenanordnung handelt es sich bei der Leiterplatte um eine Multi-Layer-Leiterplatte, wobei der Feldwandler zur Signalverbindung zwischen zwei Ebenen der Leiterplatte dient.

Weiterhin kann die Koplanar-Streifenleitung in einer ersten Metallisierungsebene der Leiterplatte angeordnet sein, wobei die Leiterplatte in einer zweiten oder dritten Metallisierungsebene eine Streifenleitung aufweist, welche über den Feldwandler mit der Koplanar-Streifenleitung durch mindestens eine Schicht der Leiterplatte hindurch elektrisch in Verbindung steht.

Die Multi-Layer-Leiterplatte kann mindestens zwei Metallisierungsebenen umfassen, bspw. jeweils eine auf ihrer Oberseite und ihrer Unterseite. Es sind jedoch auch Ausführungsformen denkbar, bei welchem die Multi-Layer-Leiterplatte mehr als zwei Metallisierungsebenen aufweist.

Bei der Streifenleitung, welche in der zweiten oder dritten Metallisierungsebene der Leiterplatte angeordnet ist, kann es sich in einem möglichen Ausführungsbeispiel um eine Mikrostreifenleitung handeln. Alternativ ist jedoch auch hier der Einsatz einer Koplanar-Streifenleitung denkbar.

In einer möglichen Ausführungsform der vorliegenden Erfindung kann der Feldwandler in einer ersten Metallisierungsebene der Leiterplatte einen Koplanar-Umwandlungsabschnitt und in einer zweiten oder dritten Metallisierungsebene der Leiterplatte ein Streifenleitungsabschnitt aufweisen, wobei der Feldwandler weiterhin einen Koaxial-Leitungsabschnitt aufweist, welcher den Koplanar-Umwandlungsabschnitt durch mindestens eine Schicht der Leiterplatte hindurch mit einem Streifenleitungsabschnitt verbindet. Der Streifenleitungsabschnitt dient dabei ebenfalls als Umwandlungsabschnitt zur Umwandlung eines Streifenleitungsfeldes in das Koaxialfeld des Koaxial-Leitungsabschnitts. Der Streifenleitungsabschnitt kann dabei in einer möglichen Ausführungsform als Koplanar-Umwandlungsabschnitt ausgeführt sein. Alternativ kann der Streifenleitungsabschnitt als Mikrostreifen-Umwandlungsabschnitt ausgeführt sein.

In einer möglichen Ausführungsform der vorliegenden Erfindung kann zwischen der ersten Metallisierungsebene des Koplanar-Umwandlungsabschnitts und der dritten Metallisierungsebene des Streifenleitungsabschnitts eine zweite Metallisierungsebene der Leiterplatte vorgesehen sein, welche bevorzugt als Masseebene dient. Insbesondere wenn es sich bei dem Streifenleitungsabschnitt um ein Mikrostreifenleitungsabschnitt handelt, kann die Masseebene dabei als Masseebene der Mikrostreifenleitung dienen. Bevorzugt führt in diesem Fall der Koaxial-Leitungsabschnitts des Feldwandlers das Koaxial-Feld durch die zweite Metallisierungsebene hindurch.

Bevorzugt sind Vias vorgesehen, welche die zweite und/oder dritte Metallisierungsebene mit der ersten Metallisierungsebene, in welcher der Strahler angeordnet ist, verbinden und welche den Außenleiter des Koaxial-Leitungsabschnitts des Feldwandlers bilden. Die zweite Metallisierungsebene kann dabei als Masseebene dienen, und im Bereich des Feldwandlers einen kreisförmigen Ausschnitt aufweisen. Bevorzugt sind die Vias dabei am Umfang eines solchen kreisförmigen Ausschnittes der zweiten Metallisierungsebene angeordnet. Bevorzugt erstrecken sich die Vias von der ersten Metallisierungsebene über die zweite Metallisierungsebene zur dritten Metallisierungsebene.

Dient der erfindungsgemäße Feldwandler wie oben beschrieben der internen Verbindung zweier Metallisierungsebenen der erfindungsgemäßen Leiterplattenanordnung, hat dies den Vorteil, dass die Führung der Leitungsabschnitte unabhängig von der Anordnung der Strahler auf der Leiterplatte vorgenommen werden kann. Insbesondere können hierdurch Leitungsabschnitte auch durch den Bereich hindurch geführt werden, in welchem in einer anderen Ebene der Strahler vorgesehen ist.

Üblicherweise werden Leiterplattenstrahler gemäß dem Stand der Technik zusammen mit einem externen Reflektor eingesetzt, wobei der auf der Leiterplatte angeordnete Strahler üblicherweise im Abstand von ca. λ/2 oder λ/4 von dem externen Reflektor angeordnet wird. Hierdurch wird die Direktivität des von dem Strahler ausgestrahlten Feldes beeinflusst. Eine solche Ausgestaltung, bei welcher für den erfindungsgemäßen Strahler ein externer Reflektor eingesetzt wird, ist auch gemäß der vorliegenden Erfindung denkbar, und zwar sowohl dann, wenn der Strahler in die Leiterplatte integriert ist, als auch dann, wenn der Strahler ein separates Bauelement zur Leiterplatte bildet.

Besonders bevorzugt wird gemäß der vorliegenden Erfindung der Reflektor des Strahlers jedoch durch eine zweite Metallisierungsebene der Leiterplatte gebildet. Dieser Aspekt ist auch unabhängig von dem oben dargestellten ersten Aspekt Gegenstand der vorliegenden Erfindung, und zwar insbesondere dann, wenn der Strahler in die Leiterplatte integriert ist.

Die vorliegende Erfindung umfasst daher in einer bevorzugten Ausgestaltung eine Leiterplattenanordnung mit einer Leiterplatte, deren Metallisierung in mindestens einer ersten Metallisierungsebene einen Strahler umfasst. Erfindungsgemäß ist dabei vorgesehen, dass der Reflektor des Strahlers durch eine zweite Metallisierungsebene der Leiterplatte gebildet wird. Bevorzugt handelt es sich bei dem Strahler wiederrum um einen Mobilfunkstrahler.

Die erfindungsgemäße Leiterplatte bildet damit durch Ihre Metallisierungen in unterschiedlichen Ebenen sowohl den Strahler, als auch den Reflektor für den Strahler. Hierdurch ergibt sich eine enorm kompakte Bauweise.

Bei der erfindungsgemäßen Leiterplattenanordnung beträgt bevorzugt der Abstand zwischen der ersten Metallisierungsebene und der zweiten Metallisierungsebene zwischen 0,1λ und 0,7λ, insbesondere zwischen 0,15λ und 0,35λ oder zwischen 0,4λ und 0,6λ. Bei λ handelt es sich dabei um die Wellenlänge der Mittenfrequenz des untersten Resonanzfrequenzbereichs der erfindungsgemäßen Antenne, und/oder um die Wellenlänge der Mittenfrequenz des Frequenzbandes, für welches die Antenne eingesetzt wird. Dabei ist auf die Wellenlänge im Dielektrikum der Leiterplatte abzustellen.

Die Leiterplatte weist bevorzugt zwischen der ersten Metallisierungsebene, in welcher der Strahler ausgebildet ist, und der zweiten Metallisierungsebene, in welcher ein Reflektor ausbildet ist, mindestens eine dielektrische Schicht auf. In möglichen Ausführungsbeispielen können jedoch auch mehrere dielektrische Schichten vorhanden sein. Bevorzugt sind dabei die erste Metallisierungsebene, die zweite Metallisierungsebene und die dazwischen liegenden dielektrischen Schichten miteinander laminiert. Die Leiterplatte bildet damit eine einstückige Multi-Layer-Anordnung.

Es ist jedoch ebenfalls denkbar, eine solche Leiterplatte aus zwei separaten Leiterplattenschichten aufzubauen, welche jeweils eine Metallisierungsebene und mindestens eine dielektrische Schicht umfassen, wobei die beiden dielektrischen Schichten aufeinander gelegt und gegebenenfalls miteinander verbunden werden.

Die Metallisierungsebene, welche den Reflektor des erfindungsgemäßen Strahlers bildet, kann als Masseebene ausgeführt sein.

Bei der ersten und der zweiten Metallisierungsebene kann es sich um beliebige Metallisierungsebenen der Multi-Layer-Leiterplatte handeln, welche beliebig innerhalb der Layer-Struktur der Leiterplatte angeordnet seien können. In einer möglichen Ausführungsform kann es sich bei der ersten und/oder der zweiten Metallisierungsebene um eine äußere Metallisierungsebene der Leiterplatte handeln, insbesondere um eine obere bzw. untere Metallisierungsebene. In anderen Ausführungsformen kann es sich bei der ersten und/oder der zweiten Metallisierungsebene um eine innere Metallisierungsebene der Leiterplatte handeln. Weiterhin können unter und/oder über der ersten und/oder der zweiten Metallisierungsebene eine oder mehrere weitere Metallisierungsebenen vorgesehen sein.

Weiterhin kann vorgesehen sein, dass der Strahler durch eine Streifenleitung versorgt wird, welche in einer dritten Metallisierungsebene der Leiterplatte verläuft. Insbesondere kann die den Reflektor bildende zweite Metallisierungsebene zwischen der die Streifenleitung bildenden dritten Metallisierungsebene und der ersten Metallisierungsebene des Strahlers verlaufen. Hierdurch ist es wiederrum möglich, die Streifenleitung, welche den Strahler mit Signalen versorgt, unabhängig von der Anordnung des Strahlers auf der Leiterplatte zu platzieren. Die Streifenleitung kann in diesem Fall gegebenenfalls auch in dem Bereich, in welchem der Strahler angeordnet ist, verlaufen. Als Streifenleitung kann dabei beispielsweise eine Mikrostreifenleitung eingesetzt werden. In diesem Fall dient die den Reflektor bildende zweite Metallisierungsebene bevorzugt als Masseebene für die Mikrostreifenleitung. Alternativ kann die Streifenleitung jedoch auch als eine Koplanar-Streifenleitung ausgeführt sein.

Weiterhin kann vorgesehen sein, dass der Strahler und die Streifenleitung durch eine Schicht der Leiterplatte hindurch mittels eines Feldwandlers elektrisch in Verbindung stehen. Bevorzugt ist dabei vorgesehen, dass der Feldwandler ein Koaxialfeld durch mindestens eine Schicht der Leiterplatte hindurch führt. Alternativ oder zusätzlich kann vorgesehen sein, dass die Metallisierung der Leiterplatte mindestens eine Koplanar-Streifenleitung zur Signalversorgung des Strahlers umfasst. Bevorzugt ist diese in der ersten Metallisierungsebene, welche den Strahler umfasst, angeordnet.

Insbesondere kann ein erfindungsgemäßer Feldwandler, wie er oben beschrieben wurde, das Koaxialfeld durch die zweite Metallisierungsebene hindurch führen.

Bevorzugt sind in diesem Fall Vias vorgesehen, welche die zweite Metallisierungsebene des Reflektors mit der ersten Metallisierungsebene, in welcher der Strahler angeordnet ist, verbinden und welche einen Teil des Außenleiters des Koaxial-Leitungsabschnitts des Feldwandlers bilden. Die zweite Metallisierungsebene kann dabei als Masseebene dienen, und im Bereich des Feldwandlers einen kreisförmigen Ausschnitt aufweisen. Bevorzugt sind die Vias dabei am Umfang eines solchen kreisförmigen Ausschnittes der Masseebene angeordnet.

Dient der Feldwandler gleichzeitig dem Anschluss eines Koaxialkabels, so ist der Außenleiter bevorzugt mit der Masseebene verbunden, insbesondere galvanisch verbunden.

Dient der Feldwandler dagegen der internen Signalleitung von einer Ebene zu einer anderen Ebene der Leiterplatte, so sind die Vias bevorzugt zwischen den beiden Ebenen der Leiterplatte, zwischen welchen die Signale geleitet werden sollen, vorgesehen. Insbesondere können sich die Vias dabei von der ersten Metallisierungsebene, in welcher der Strahler angeordnet ist, zu der zweiten Metallisierungsebene der Leiterplatte, welche den Reflektor bildet, und von dort zu einer dritten Metallisierungsebene der Leiterplatte erstrecken, in welcher bevorzugt eine Streifenleitung vorgesehen ist, welche den Strahler versorgt.

Weitere bevorzugte Ausgestaltungen der vorliegenden Erfindung werden im Folgenden näher beschrieben:
Bevorzugt ist der Strahler oder sind die Strahler, welche gemäß der vorliegenden Erfindung durch eine Metallisierungsebene der Leiterplatte gebildet werden, von einem Rahmen umgeben, welcher durch Vias gebildet ist. Der Rahmen kann alternativ oder zusätzlich Metallisierungsabschnitte umfassen. Bevorzugt umfasst der Rahmen einen rahmenförmigen Metallisierungsabschnitt, welcher weiter bevorzugt mit den Vias elektrisch gekoppelt ist, insbesondere galvanisch. Der rahmenförmige Metallisierungsabschnitt kann sich in der ersten Metallisierungsebene und/oder in einer über oder unter der ersten Metallisierungsebene liegenden Metallisierungsebene erstrecken.

Die Verwendung eines in die Leiterplatte integrierten Rahmens ist insbesondere bei einer Leiterplattenanordnung gemäß dem zweiten Aspekt der vorliegenden Erfindung von Vorteil, da hierdurch sowohl der Strahler, als auch die Reflektorebene, als auch ein Reflektorrahmen in die Leiterplatte integriert sind.

Bevorzugt erstrecken sich die Vias, welche den Rahmen bilden, in diesem Fall von der zweiten Metallisierungsebene des Reflektors zur ersten Metallisierungsebene des Strahlers. Bevorzugt stehen die Vias mit einer in der zweiten Metallisierungsebene gebildeten Masseebene der Leiterplatte in Verbindung, insbesondere galvanisch.

Erfindungsgemäß können der oder die Strahler, welche durch eine Metallisierungsebene der Leiterplatte gebildet werden, als Dipolstrahler und/oder als Dipol-Schlitz-Strahler ausgeführt sein. Bei einer Ausgestaltung als Dipol-Strahler kann die Metallisierung zwei Dipolarme bilden, welche sich von einem Mittelpunkt nach Außen erstrecken. Im Bereich des Mittepunktes eines solchen Dipols stehen die beiden Dipolarme bevorzugt jeweils mit einer Leitungsbahn der Koplanar-Streifenleitung in Verbindung.

Ist der Strahler als Dipol-Schlitz-Strahler ausgeführt, so können die beiden Dipolarme in einem Ausschnitt in einer Metallisierungsebene der Leiterplatte angeordnet sein.

Der erfindungsgemäße Strahler bzw. die erfindungsgemäßen Strahler sind gemäß der vorliegenden Erfindung als differentielle Strahler ausgestaltet. Dabei stehen die zwei Dipolarme eines Dipolstrahlers und/oder Dipol-Schlitz-Strahlers jeweils mit einer Leitungsbahn einer Koplanar-Streifenleitung in Verbindung.

In einer möglichen Ausführungsform kann eine Mehrzahl von erfindungsgemäßen Strahlern in Form eines Arrays auf der Leiterplatte angeordnet sein. Insbesondere können dabei mehrere Strahlerpaare bzw. Strahlerblöcke, welche jeweils über einen erfindungsgemäßen Feldwandler parallel mit Signalen versorgt werden, auf einer Leiterplatte angeordnet sein. Die Strahler können dabei in Reihen und/oder Schlitzen angeordnet sein.

In einer möglichen Ausführungsform sind die einzelnen Strahler und/oder Strahlerpaare eines solchen Arrays separat mit Signalen versorgbar. Dabei können die Signalleitungen in die Leiterplattenanordnung insbesondere in die erfindungsgemäße Leiterplatte integriert sein.

In einer bevorzugten Ausführungsform sind die einzelnen Strahler und/oder Strahlerpaare eines solchen Arrays über eine gemeinsame Signalleitung mit Signalen versorgbar. Dabei kann die Signalleitung und/oder die Leistungsteiler zum parallelen Anschluss der Strahler an die Signalleitung in die Leiterplatte integriert sein.

Weiterhin kann es sich bei der durch eine erfindungsgemäße Leiterplattenanordnung gebildeten Antenne um eine aktive Antenne handeln. Bevorzugt ist dabei mindestens ein aktives Bauelement, insbesondere ein Verstärker, auf der erfindungsgemäßen Leiterplatte angeordnet und/oder in die erfindungsgemäße Leiterplatte integriert.

Bevorzugt weisen der Strahler bzw. die Strahler der erfindungsgemäßen Leiterplattenanordnung einen untersten Resonanzfrequenzbereich und/oder eine Mittenfrequenz eines untersten Resonanzfrequenzbereiches auf, welche in einen Frequenzbereich zwischen 3 GHz und 300 GHz liegt. Bevorzugt liegt der Resonanzfrequenzbereich und/oder die Mittenfrequenz des untersten Resonanzfrequenzbereiches in einem Frequenzbereich zwischen 20 GHz und 60 GHz. In diesem Frequenzbereich ist insbesondere auch die Ausgestaltung gemäß dem zweiten Aspekt von besonderem Vorteil, da der geforderte Abstand von ca. λ/4 oder λ/2 zwischen den Metallisierungsebenen bei diesem Frequenzbereich mit relativ normalen Schichtdicken einer Leiterplatte erreicht werden kann.

Die Leiterplattenanordnung gemäß der vorliegenden Erfindung kann ausschließlich die erfindungsgemäße Leiterplatte umfassen, oder weitere Komponenten aufweisen.

Die vorliegende Erfindung umfasst weiterhin ein Mobilfunkgerät mit einer Leiterplattenanordnung, wie sie oben beschrieben wurde. Bei dem Mobilfunkgerät kann es sich um eine Mobilfunk-Basisstation handeln. In diesem Fall ist die erfindungsgemäße Leiterplattenordnung bevorzugt als ein Strahler-Array ausgestaltet, d.h. auf der Leiterplatte ist eine Mehrzahl von Strahlern und/oder Strahlerpaaren in Form eines Arrays angeordnet.

Bei dem Mobilfunkgerät kann es sich jedoch auch um ein Mobilfunk-Repeater handeln, und/oder um ein Mobilfunk-Endgerät, insbesondere um ein Mobiltelefon. Aufgrund der kleinen Abmessungen der erfindungsgemäßen Leiterplattenanordung eignet sich diese auch als Antenne für Mobilfunk-Repeater und/oder Mobilfunk-Endgeräte.

Die vorliegende Erfindung wird nun anhand von Ausführungsbeispielen sowie Zeichnungen näher beschrieben:
Dabei zeigen:
- Fig. 1a:: Ein erstes Ausführungsbeispiel einer erfindungsgemäßen Koplanar-Streifenleitung,
- Fig. 1b:: ein zweites Ausführungsbeispiel einer erfindungsgemäßen Koplanar-Streifenleitung,
- Fig. 2:: ein Ausführungsbeispiel einer nicht beanspruchten Leiterplattenanordnung mit einem Feldwandler, an welchen eine einzige Koplanar-Streifenleitung angeschlossen ist,
- Fig. 3:: zwei Varianten einer Leiterplattenanordnung, bei welcher der in Fig. 2 gezeigte Feldwandler in unterschiedlicher Art und Weise an einen Strahler angeschlossen ist,
- Fig. 4:: ein erstes Ausführungsbeispiel einer erfindungsgemäßen Leiterplattenanordnung mit einem Feldwandler, welcher gleichzeitig als Leistungsteiler zur elektrischen Anbindung zweier Strahler dient, wobei der Feldwandler das Koaxialfeld in zwei gegenphasige Koplanar-Streifenleitungsfelder umwandelt,
- Fig. 5:: Varianten des in Fig. 4 gezeigten Ausführungsbeispiels,
- Fig. 6a:: eine erste Variante der Ankopplung eines Koaxial-Leitungsabschnittes an den Koplanar-Umwandlungsabschnitt des Feldwandlers,
- Fig. 6b:: eine zweite Variante der Ankopplung eines Koaxial-Leitungsabschnitts an einen Koplanar-Umwandlungsabschnitt,
- Fig. 7:: ein zweites Ausführungsbeispiel einer nicht beanspruchten Leiterplattenanordnung mit einem Feldwandier, welcher gleichzeitig als Leistungsteiler dient, wobei der Feldwandler das Koaxialfeld in zwei gleichphasige Koplanar-Streifenleitungsfelder umwandelt,
- Fig. 8a:: die Anbindung des in Fig. 4 gezeigten ersten Ausführungsbeispiels eines als Leistungsteiler dienenden Feldwandlers an zwei Strahler,
- Fig. 8b:: die Anbindung des in Fig. 7 gezeigten zweiten Ausführungsbeispiels eines als Leistungsteiler dienenden Feldwandlers an zwei Strahler,
- Fig. 9:: mehrere Varianten der Anordnung und Ausgestaltung der Strahler bei der in Fig. 8a gezeigten Anbindung,
- Fig. 10:: zwei Ausführungsbeispiele einer erfindungsgemäßen Leiterplattenanordnung, bei welchen sowohl ein Feldwandler gemäß dem ersten Aspekt, als auch ein durch eine Metallisierung gebildeter Reflektor gemäß dem zweiten Aspekt der vorliegenden Erfindung verwirklicht sind,
- Fig. 11:: ein weiteres Ausführungsbeispiel, bei welchem der erste und zweite Aspekt verwirklicht sind, wobei der Feldwandler gleichzeitig zum Anschluss eines Koaxialkabels dient,
- Fig. 12:: eine Darstellung des in Fig. 11 gezeigten Ausführungsbeispiels, mit mehreren Diagrammen, welche die E-Feld-Verteilung zeigen,
- Fig. 13:: bei welchem der erste und zweite Aspekt verwirklicht sind, wobei der Feldwandler der internen Signalübertragung zwischen unterschiedlichen Ebenen der Leiterplatte dient,
- Fig. 14:: ein weiteres Ausführungsbeispiel, bei welchem zwei Strahlerpaare als Antennenarray in die Leiterplatte integriert sind, in einer Draufsicht,
- Fig. 15:: das in Fig. 14 gezeigte Ausführungsbeispiel in einer perspektivischen Ansicht seitlich von oben, seitlich von unten und in einer Schnittansicht, und
- Fig. 16:: ein Smith-Chart, sowie Fernfelddiagramme in horizontaler und vertikaler Richtung, des in Fig. 14 und 15 dargestellten Ausführungsbeispiels.

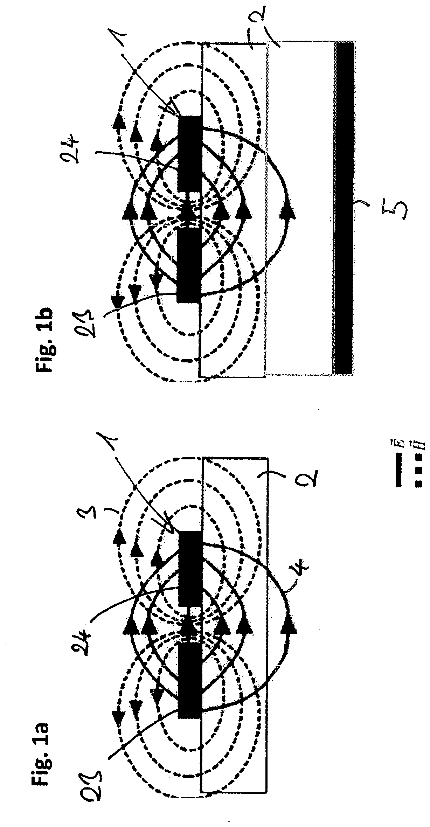

Im Rahmen der vorliegenden Erfindung wird bei einer Leiterplattenanordung gemäß dem ersten Aspekt eine Koplanar-Streifenleitung zur Signalversorgung eines Strahlers eingesetzt. Fig. 1a und 1b zeigen zwei Ausführungsbeispiele einer solchen Koplanar-Streifenleitung.

Die Koplanar-Streifenleitung 1 umfasst dabei in beiden Ausführungsbeispielen zwei Leitungsbahnen 23 und 24, welche auf einem dielektrischen Substrat 2 der Leiterplatte angeordnet sind und in einem gewissen Abstand voneinander verlaufen. Die eine Leitungsbahn ist von der anderen Leitungsbahn nur durch einen Schlitz 22 getrennt. Beide Leitungsbahnen befinden sich in der selben Ebene, d.h. sind in der selben Metallisierungsebene der Leiterplatte gebildet. In Fig. 1a und 1b ist das E-Feld und das H-Feld einer solchen Koplanar-Streifenleitung eingezeichnet. Das E-Feld verläuft von der einen Leitungsbahn 23 zur anderen Leitungsbahn 24. Das H-Feld umgibt jeweils eine der Leitungsbahnen 23 oder 24 durch den Schlitz 22 hindurch.

Anders als bei einer Mikrostreifenleitung ist bei einer Koplanar-Streifenleitung keine den Leitungsbahnen 23 und 24 gegenüberliegende Masseebene notwendig. Fig. 1a zeigt daher ein Ausführungsbeispiel, bei welcher den beiden Leitungsbahnen 23 und 24 keine Masseebene über das Dielektrikum 2 gegenüber liegt. Allerdings kann eine solche Masseebene auch vorhanden sein. Fig. 1b zeigt ein solches Ausführungsbeispiel, bei welcher den beiden Leitungsbahnen 23 und 24 die Masseebene 5 über das Dielektrikum 2 gegenüber liegt. Solche Ausführungsformen werden teilweise auch als Quasi-Koplanar-Streifenleitungen bezeichnet, und stellen ebenfalls Koplanar-Streifenleitungen im Sinne der vorliegenden Erfindung dar.

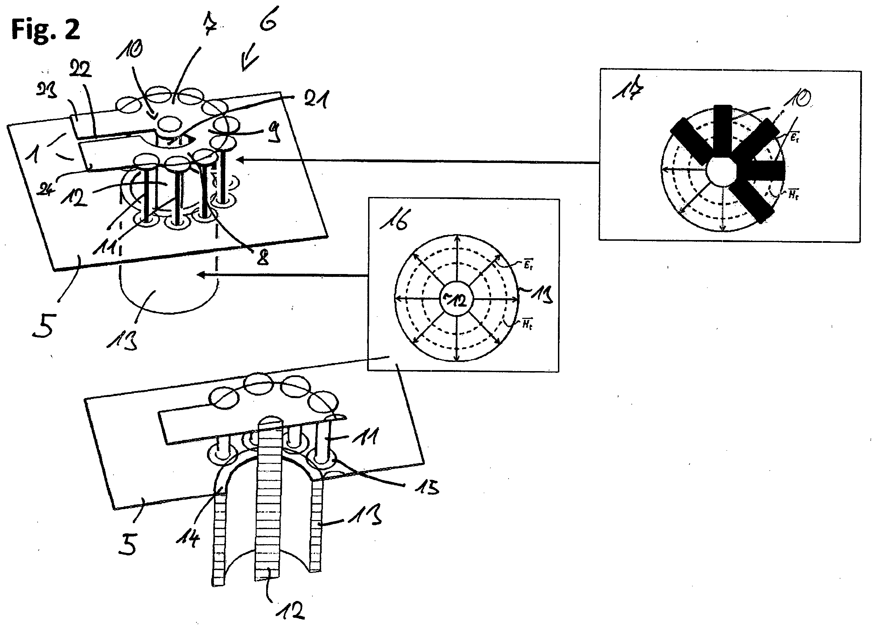

In Fig. 2 ist ein Ausführungsbeispiel einer nicht beanspruchten Leiterplattenanordnung dargestellt. Fig. 2 zeigt dabei lediglich die metallischen Teile eines Feldwandlers, während das zwischen den Metallisierungsebenen der Leiterplatte vorgesehene dielektrische Substrat der besseren Übersicht halber nicht dargestellt wurde.

Der in Fig. 2 dargestellte Feldwandler steht dabei mit einer Koplanar-Streifenleitung 1, welche in Fig. 2 verkürzt dargestellt ist, in Verbindung, und führt ein Koaxialfeld durch das Substrat der Leiterplatte hindurch und wandelt es in das Koplanar-Streifenleitungsfeld der Koplanar-Streifenleitung 1 um.

Hierfür weist der Feldwandler einen Koaxial-Leitungsabschnitt auf, welcher von einer Unterseite des Substrats zur Oberseite des Substrats durch dieses hindurch verläuft. Weiterhin weist der Feldwandler ein Koplanar-Umwandlungsabschnitt auf, welcher durch Metallisierungsabschnitte der Leiterplatte gebildet wird und mit der Koplanar-Streifenleitung in Verbindung steht.

Im Ausführungsbeispiel wird der Außenleiter des Koaxial-Leitungsabschnittes durch Vias 11 gebildet, d.h. durch elektrisch leitende Durchkontaktierungen, welche durch das Substrat der Leiterplatte hindurch gehen und einen Innenleiter 12 ringförmig umgeben. Dieser Innenleiter 12 wird im Ausführungsbeispiel durch den Innenleiter einer Koaxialkabels gebildet, welches im Bereich des Feldwandlers an die Leiterplatte angeschlossen ist. Alternativ könnte auch der Innenleiter durch einen Via gebildet werden.

Der Koplanar-Umwandlungsabschnitt umfasst zwei Außenleitungsabschnitte 7 und 8, welche sich im Bereich des Außenleiters des Koaxial-Leitungsabschnitts erstrecken und mit diesem elektrisch kontaktiert sind. Bei den in Fig. 2 gezeigten Ausführungsbeispiel sind die beiden Außenleitungsabschnitte 7 und 8 an einem Ende, im Bereich 9, miteinander verbunden. Mit ihrem anderen Ende stehen die beiden Außenleitungsabschnitte 7 und 8 mit den beiden Leitungsbahnen 23 und 24 der Koplanar-Streifenleitung in Verbindung. Der zwischen den Leitungsbahnen der Koplanar-Streifenleitung angeordnete Schlitz 22 erstreckt sich in den Bereich des Koplanar-Umwandlungsabschnittes, und verläuft dort zwischen einem der Außenleitungsabschnitte und dem Innenleiter 12 als Schlitz 21. Der Schlitz 21 ist im Ausführungsbeispiel bereiter ausgeführt als der Schlitz 22 zwischen den beiden Leitungsbahnen der Koplanar-Streifenleitung 1.

Der Schlitz 21 erstreckt sich nicht um den gesamten Innenleiter 12 herum, sondern wird durch eine Abschlussfläche 10 begrenzt, welche den Außenleitungsabschnitt 7 mit dem Innenleiter 12 verbindet.

Hierdurch wird das durch den Axialleitungsabschnitt senkrecht durch die Leiterplatte hindurch geleitete Koaxialfeld in einem Teil-Umfangsbereich blockiert, und so in das Koplanar-Streifenleitungsfeld umgewandelt, welches der Koplanar-Streifenfeldleitung zugeführt wird, die sich entlang der Ebene der Leiterplatte erstreckt.

In Fig. 2 ist in einem ersten Diagramm 16 das sich zwischen Innenleiter 12 und Außenleiter 13 des Koaxial-Leitungsabschnitts erstreckende Koaxialfeld gezeigt, und in einem zweiten Diagramm 17 das durch die Abschlussfläche 10 teilweise blockierte Feld, welches in dem Schlitz 21 auf der Ebene des Koplanar-Umwandlungsabschnittes verbleibt.

Bei dem in Fig. 2 dargestellten Ausführungsbeispiel dient der Feldwandler gleichzeitig als Anschluss eines Koaxialkabels an die Leiterplatte. Das Koaxialkabel weist einen Außenleiter 13 und einen Innenleiter 12 auf. Der Innenleiter 12 erstreckt sich im Ausführungsbeispiel durch eine Bohrung im Substrat der Leiterplatte bis auf die Ebene des Koplanar-Umwandlungsabschnittes, und ist im dargestellten Ausführungsbeispiel mit der Abschlussfläche 10 kontaktiert. Die Kontaktierung erfolgt im Ausführungsbeispiel galvanisch.

Der Außenleiter 13 des Koaxialkabels endet dagegen im Bereich der Unterseite der Leiterplatte, und wird durch die Vias 11, welche durch das Substrat der Leiterplatte hindurchgehen, verlängert. Die Vias stehen auf der einen Seite mit dem Außenleiter 13 des Koaxialkabels in Verbindung, und sind auf der anderen Seite mit dem Koplanar-Umwandlungsabschnitt kontaktiert. Insbesondere kontaktieren die Vias dabei die beiden Außenleitungsabschnitte 7 und 8 des Koplanar-Umwandlungsabschnitts.

Im dargestellten Ausführungsbeispiel weist die Leiterplatte auf Ihrer Unterseite eine durchgehende Metallisierungsschicht 5 auf, welche als Masseebene dient. Die Koplanar-Streifenleitung ist bei dem Ausführungsbeispiel gemäß Fig. 2 daher so ausgeführt, wie dies in Fig. 1b dargestellt ist. Die Metallisierungsschicht 5 steht dabei im Bereich 14 mit dem Außenleiter 13 des Koaxialkabels elektrisch in Verbindung, sowie mit den Vias 11 im Bereich 15.

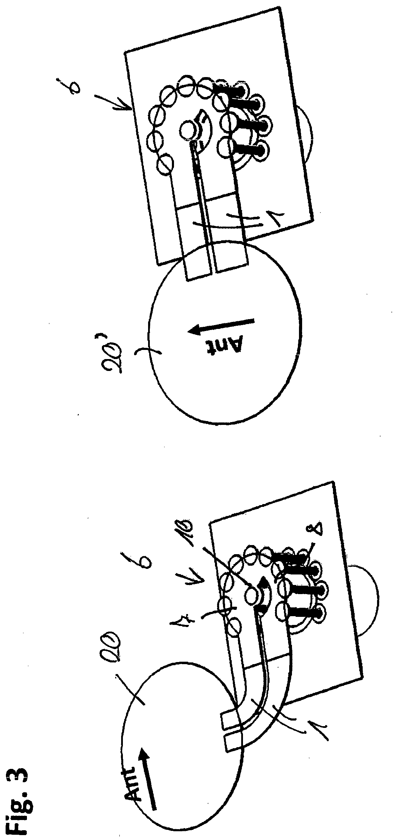

In Fig. 3 sind nun zwei Ausführungsbeispiele einer nicht beanspruchten Leiterplattenanordnung mit einem Feldwandler 6 gemäß dem Ausführungsbeispiel in Fig. 2 dargestellt, wobei die Koplanar-Streifenleitung 1 jeweils einen Strahler 20 bzw. 20' mit Signalen versorgt. Je nach Führung der Koplanar-Streifenleitung kann dabei die Polarität des Strahlers 20 bzw. 20' relativ zur Ausrichtung des Koplanar-Umwandlungsabschnittes frei gewählt werden.

Die Antenne ist in Fig. 3 nicht näher spezifiziert. Gegebenenfalls könnte dabei ein zur Leiterplatte separater Strahler eingesetzt werden, welcher durch die Leiterplattenanordnung lediglich gespeist wird, und beispielsweise auf der Leiterplatte aufgesetzt ist. Bevorzugt ist der Strahler jedoch durch eine Metallisierung der Leiterplatte gebildet, und erstreckt sich bevorzugt in der gleichen Metallisierungsebene wie die Koplanar-Streifenleitung 1. Als Strahler wird dabei bevorzugt ein symmetrisch gespeister differentieller Strahler eingesetzt.

Bei dem in Fig. 2 dargestellten Ausführungsbeispiel hat der Feldwandler zum einen die Funktion, das Koaxialfeld durch die Leiterplatte hindurch auf die Ebene der Metallisierung zu leiten, in welcher die Koplanar-Streifenleitung angeordnet ist. Weiterhin dient der Feldwandler dem Anschluss eines Koaxialkabels, welches senkrecht an der Leiterplatte angeschlossen ist und durch den Koaxial-Leitungsabschnitt des Feldwandlers durch die Leiterplatte hindurch verlängert wird.

Wie im Folgenden noch ausführlicher dargestellt, kann auf die zweite Funktion, d.h. die Anbindung eines Koaxialkabels, jedoch auch verzichtet werden, und der Koaxial-Leitungsabschnitt zur Signalleitung zwischen unterschiedlichen Ebenen einer Multi-Layer Leiterplatte eingesetzt werden.

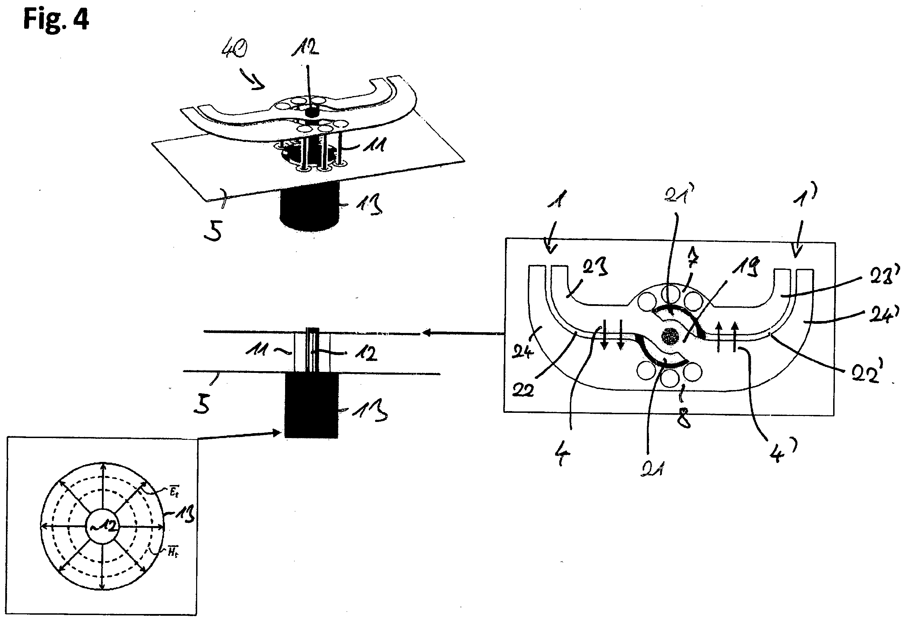

Erfindungsgemäß dient der Feldwandler zusätzlich zu diesen bisher beschriebenen Funktionenen als Leistungsteiler. Fig. 4 zeigt ein erstes Ausführungsbeispiel eines solchen erfindungsgemäßen Feldwandlers, welcher gleichzeitig als Leistungsteiler zur Versorgung zweier Strahler dient. Die beiden Strahler sind in Fig. 4 wiederrum nicht dargestellt, werden aber durch die Koplanar-Streifenleitung 1 und 1' mit Signalen versorgt und sind parallel an den Feldwandler angeschlossen. Der Feldwandler in Fig. 4 arbeitet nach dem gleichen Grundprinzip, welches bereits oben im Hinblick auf das - als solches nicht beanspruchte - Ausführungsbeispiel gemäß Fig. 2 näher dargestellt wurde.

Der Feldwandler weist einen Koaxial-Leitungsabschnitt auf, welcher das Koaxialfeld durch eine Schicht der Leiterplatte zu einem Koplanar-Umwandlungsabschnitt führt. Der Koaxial-Leitungsabschnitt umfasst eine Reihe von Vias 11, welche den Außenleiter des Koaxial-Leitungsabschnitts bilden und einen Innenleiter 12 des Koaxial-Leitungsabschnitts umgeben. Der Koplanar-Umwandlungsabschnitt umfasst zwei Außenleiterabschnitte 7 und 8, welche im Bereich des Außenleiters des Koaxial-Leitungsabschnittes verlaufen und mit diesem elektrisch kontaktiert sind.

Bei dem in Fig. 4 gezeigten Ausführungsbeispiel geht der Außenleitungsabschnitt 8 in die erste Leitungsbahn 24 der ersten Koplanar-Streifenleitung 1 über, der zweite Außenleitungsabschnitt 7 in die gegenüberliegende zweite Leitungsbahn 23' der zweiten Koplanar-Streifenleitung 1'. Die zweite Leitungsbahn 23 der ersten Koplanar-Streifenleitung 1 steht dagegen über eine Diagonalbahn 19 des Koplanar-Umwandlungsabschnittes mit der gegenüberliegenden ersten Leitungsbahn 24' der zweiten Koplanar-Streifenleitung 1' in Verbindung. Die Diagonalbahn 19 verläuft dabei radial zu dem Koaxial-Leitungsabschnitt und steht mit dem Innenleiter 12 in Verbindung.

Hierdurch bildet der Feldwandler ein Leistungsteiler, welcher das Koaxialfeld in zwei gegenphasige Koplanar-Leitungsfelder 4 und 4' umwandelt und der ersten und der zweiten Koplanar-Streifenleitung 1 und 1' zuführt.

Der Schlitz 22 zwischen den beiden Leitungsbahnen 23 und 24 der ersten Koplanar-Streifenleitung 1, sowie der Schlitz 22' zwischen den beiden Streifenleitungsbahnen 23' und 24' der zweiten Koplanar-Streifenleitung 1 ist jeweils in den Bereich zwischen den Außenleiter und dem Innenleiter des Koaxial-Leitungsabschnittes hinein zu einem Schlitz 21 bzw. 21' verlängert. Die Schlitze 21 bzw. 21' enden an der Diagonalbahn 19. Die Diagonalbahn 19 teilt hierdurch das Koaxialfeld in zwei Feldanteile, welche den beiden Koplanar-Streifenleitungen zugeführt werden.

Die Diagonalbahn 19 hat bei dem in Fig. 4 gezeigten zweiten Ausführungsbeispiel die gleiche Funktion wie die Abschlussfläche 10 bei den in Fig. 2 dargestellten Ausführungsbeispiel, wird nunmehr jedoch durch den den Schlitz 22' zwischen den beiden Leitungsbahnen 23' und 24' der zweiten Koplanar-Streifenleitung 1 verlängernden Schlitz 21' auch von der gegenüberliegenden Seite her unterbrochen.

Die Ausgestaltung des Umwandlungsabschnittes ist dabei bevorzugt punktsymmetrisch gegenüber dem Innenleiter 12 des Koaxial-Leitungsabschnittes, um das Koaxialfeld in zwei bis auf die Phasenausrichtung identische Koplanar-Streifenleitungsfelder umzuwandeln.

Bei dem in Fig. 4 dargestellten Ausführungsbeispiel wird der Außenleiter des Koaxial-Leitungsabschnittes wiederrum über Vias 11 gebildet, welche eine Metallisierungsebene 5 auf der Unterseite des Substrates mit den auf der Oberseite angeordneten Außenleitungsabschnitten 7 und 8 des Koplanar-Umwandlungsabschnitts verbinden. Der Innenleiter wird wieder durch den Innenleiter 12 eines Koaxialkabels gebildet, welches im Bereich des Feldwandlers an die Leiterplatte angeschlossen ist. Der Außenleiter 13 des Koaxialkabels steht wiederrum mit dem durch die Vias 11 gebildeten Außenleiter in Verbindung, insbesondere über die Metallisierungsebene 5.

Die Ausgestaltung entspricht dabei der bereits im Hinblick auf Fig. 2 dargestellten Ausführung. Wie bereits dort angemerkt, ist jedoch auch eine alternative Ausgestaltung denkbar, bei welcher auch der Innenleiter 12 des Koaxial-Leitungsabschnitts durch ein Via gebildet wird, und der Koaxial-Leitungsabschnitt der Signalübertragung zwischen unterschiedlichen Ebenen einer Multilayer-Leiterplatte dient.

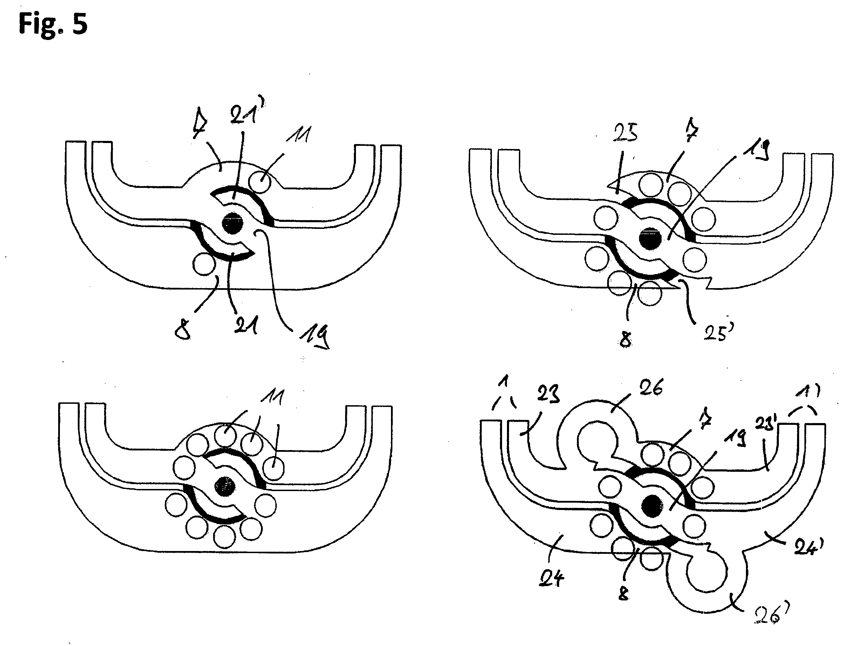

In Fig. 5 sind mehrere Varianten des in Fig. 4 dargestellten Ausführungsbeispiels dargestellt. Die Varianten unterscheiden sich zum einen durch die Anzahl der Vias 11, welche den Außenleiter des Koaxial-Leitungsabschnittes bilden. Bei dem Ausführungsbeispiel links oben ist lediglich jeweils ein Via 11 im Bereich der beiden Außenleitungsabschnitte 7 und 8 vorgesehen. Bei den übrigen Ausführungsbeispielen sind dagegen für jeden der beiden Außenleitungsabschnitte 7 und 8 mehrere Vias vorgesehen. Weiterhin ist auch im Bereich der Diagonalbahn auf beiden Seiten jeweils ein Via vorgesehen. Die Vias 11 können sich weiterhin auch bis in den Bereich der Koplanar-Streifenleitungen hinein erstrecken.

Bei dem Ausführungsbeispiel links oben stehen die beiden Außenleitungsabschnitte 7 und 8 jeweils galvanisch mit der Diagonalbahn 19 in Verbindung. Bei dem Ausführungsbeispiel rechts oben stehen die beiden Außenleitungsabschnitte dagegen über einen Schlitz 25 bzw. 25' kapazitiv mit der Diagonalbahn 19 in Verbindung.

Bei dem Ausführungsbeispiel rechts unten sind zusätzlich Ausgleichsflächen 26 bzw. 26' vorgesehen, über welche die Außenleitungsbahnen mit der Diagonalbahn in Verbindung stehen.

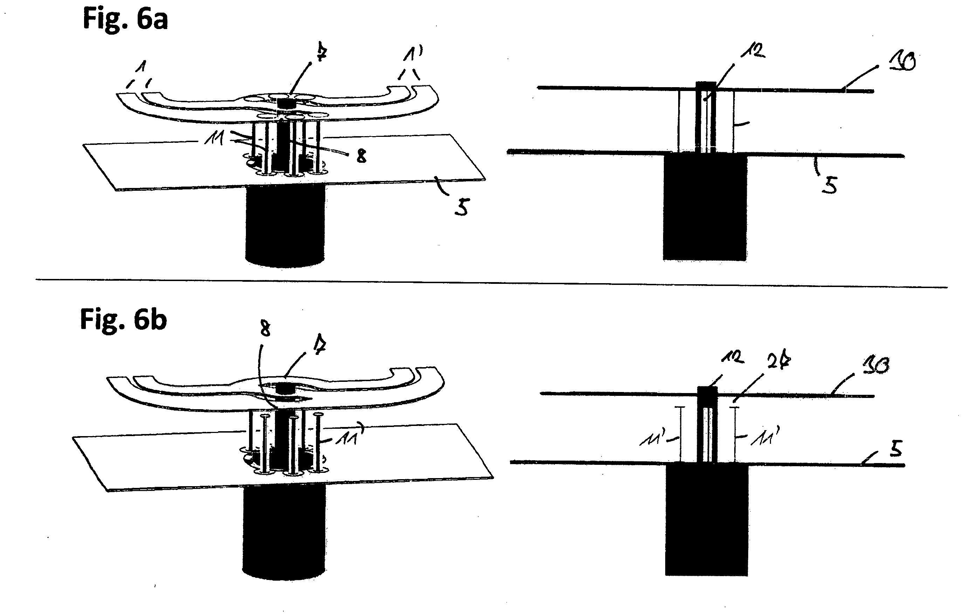

In Fig. 6a und 6b sind nun zwei Ausführungsbeispiele dafür gezeigt, wie die Vias 11 bzw. 11' mit den Metallisierungsabschnitten, welche den Koplanar-Umwandlungsabschnitt bilden, elektrisch kontaktiert sind. Bei dem in Fig. 6a dargestellten Ausführungsbeispiel erfolgt die Kontaktierung galvanisch. Bei dem in Fig. 6b dargestellten Ausführungsbeispiel erfolgt die Kontaktierung zwischen den Vias 11' und den in der Leitungsebene 30 angeordneten Metallisierungsabschnitten dagegen kapazitiv. Hierfür enden die Vias 11' unterhalb der Metallisierungsebene 30 und stehen dieser über einen Zwischenraum 27 gegenüber. Auch der Innenleiter 12 kann entweder galvanisch oder kapazitiv an den Koplanar-Umwandlungsabschnitt koppeln.

In einem nicht gezeigten Ausführungsbeispiel könnte der Außenleiter des Koaxialkabels durch eine Bohrung im Substrat der Leiterplatte hindurch geführt werden und den Außenleiter des Koaxialleitungsabschnitts bilden. Der Außenleiter kann dabei beispielsweise kapazitiv mit den Außenleitungsabschnitten des Koplanar-Umwandlungsabschnittes koppeln, indem er unterhalb der Metallisierungsebene 30 endet. Dies kann beispielsweise durch eine entsprechende Sacklochbohrung im Substrat erfolgen, oder dadurch, dass das Substrat aus zwei aufeinander liegenden Platten aufgebaut wird, von welchen nur die eine Platte die Bohrung für den Außenleiter aufweist. In einer solchen Ausführungsform kann für den Koaxial-Leitungsabschnitt auch komplett auf Vias auch verzichtet werden.

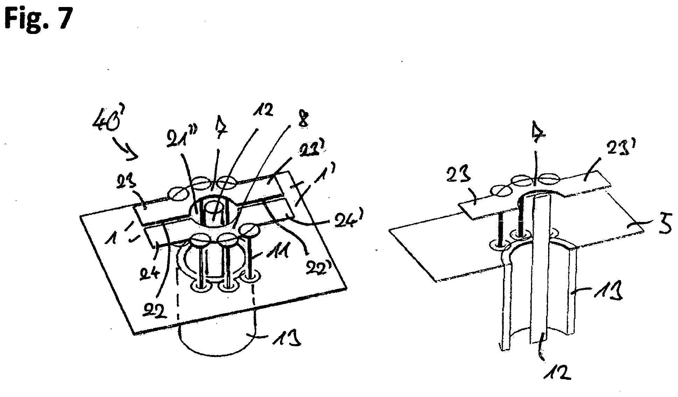

Fig. 7 zeigt ein Ausführungsbeispiel eines nicht beanspruchten Feldwandlers 40', welcher gleichzeitig als Leistungsteiler zur Versorgung zweier Strahler dient. Der generelle Aufbau des Feldwandlers und Leistungsteilers 40' entspricht dabei dem bereits in Bezug auf Fig. 4 dargestellten ersten Ausführungsbeispiel 40 eines solchen Feldwandlers und Leistungsteilers.

Das in Fig. 7 dargestellte Ausführungsbeispiel wandelt das über den Koaxial-Leitungsabschnitt zugeführte Koaxialfeld jedoch in zwei gleichphasige Koplanar-Streifenleitungsfelder um. Die beiden Außenleitungsabschnitte 7 und 8 des in Fig. 7 dargestellten Ausführungsbeispiels gehen hierfür auf beiden Seiten jeweils in eine Leitungsbahn einer Koplanar-Streifenleitung über. Konkret geht dabei die erste Leitungsbahn 24 der ersten Koplanar-Streifenleitung 1 in den Außenleitungsabschnitt 8 über, welcher auf der anderen Seite in die erste Leitungsbahn 24' der zweiten Koplanar-Streifenleitung 1' übergeht. Die gegenüberliegende Leitungsbahn 23 der ersten Koplanar-Streifenleitung 1 geht in den Außenleitungsabschnitt 7 und dieser in die erste Leitungsbahn 23' der zweiten Koplanar-Streifenleitung 1' über. Die Schlitze 22 bzw. 22' zwischen den jeweiligen Leitungsbahnen der Koplanar-Streifenleitungen gehen dabei in einen gemeinsamen, im Bereich zwischen dem Innenleiter 12 und dem Außenleiter des Koaxial-Leitungsabschnittes vorgesehenen Ringspalt 21" über.

Bei dem in Fig. 7 dargestellten Ausführungsbeispiel ist der Innenleiter 12 daher lediglich auf die Ebene der Metallisierungsabschnitte, welche den Koplanar-Umwandlungsabschnitt bilden, verlängert, jedoch nicht mit diesem Metallisierungsabschnitten elektrisch verbunden.

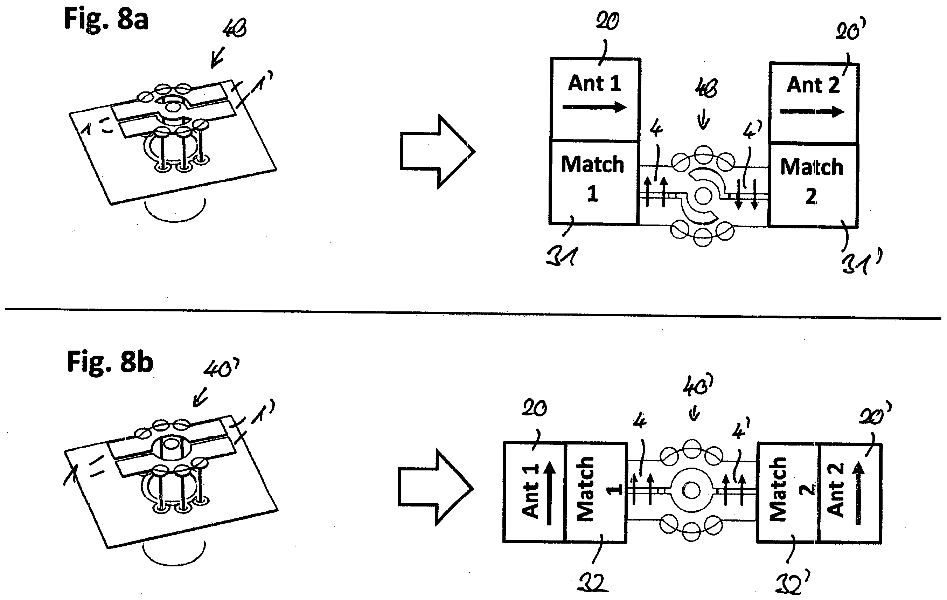

In Fig. 8a und 8b ist nun der Anschluss von zwei Strahlern 20 und 20' an die in Fig. 4 bzw. 7 gezeigten Ausführungsbeispiele eines Leistungsteilers 40 bzw. 40' gezeigt.

Fig. 8a zeigt den Anschluss der Strahler 20 und 20' an die Koplanar-Streifenleitungen 1 und 1' des in Fig. 4 gezeigten Leistungsteilers, bei welchen die Koplanar-Streifenleitungsfelder 4 und 4' gegenphasig verlaufen. Um die beiden Strahler 20 und 20' dennoch gleichphasig betreiben zu können, sind zwischen den Strahlern 20 und 20' und dem Leistungsteiler 40 Anpassungsschaltungen 31 und 31' angeordnet. Die Anpassungsschaltungen 31 und 31' können dabei einfach durch eine entsprechende Führung der Koplanar-Streifenleitungen gebildet sein. Insbesondere weisen die beiden Koplanar-Leitungen dabei zur Bildung der Anpassungsschaltung 31 und 31' unterschiedliche Richtungswechsel auf.

Insbesondere kann durch die erste Koplanar-Leitung 1 das Feld im Bereich der Anpassungsschaltung 31 um 90° nach rechts gedreht, während das Feld durch die zweite Koplanar-Streifenleitung 1' im Bereich der Anpassungsschaltung 31' um 90° nach links gedreht wird. Durch dieses in Fig. 8a dargestellte Prinzip können die beiden Strahler 20 und 20' relativ eng nebeneinander angeordnet werden.

Bei dem in Fig. 8b gezeigten Ausführungsbeispiel wird dagegen ein Leistungsteiler gemäß dem Ausführungsbeispiel in Fig. 7 dargestellt, bei welchem zwei gleichphasige Koplanar-Streifenleitungsfelder 4 und 4' erzeugt werden. Die beiden Anpassungsschaltungen 32 und 32', welche zwischen den Strahlern 20 und 20' und dem Leistungsteiler 40' angeordnet sind, verändern daher die Ausrichtung des Feldes in identischer Weise und insbesondere überhaupt nicht. Die Antennen 20 und 20' können durch die gleichphasigen Felder hierdurch gleichphasig betrieben werden.

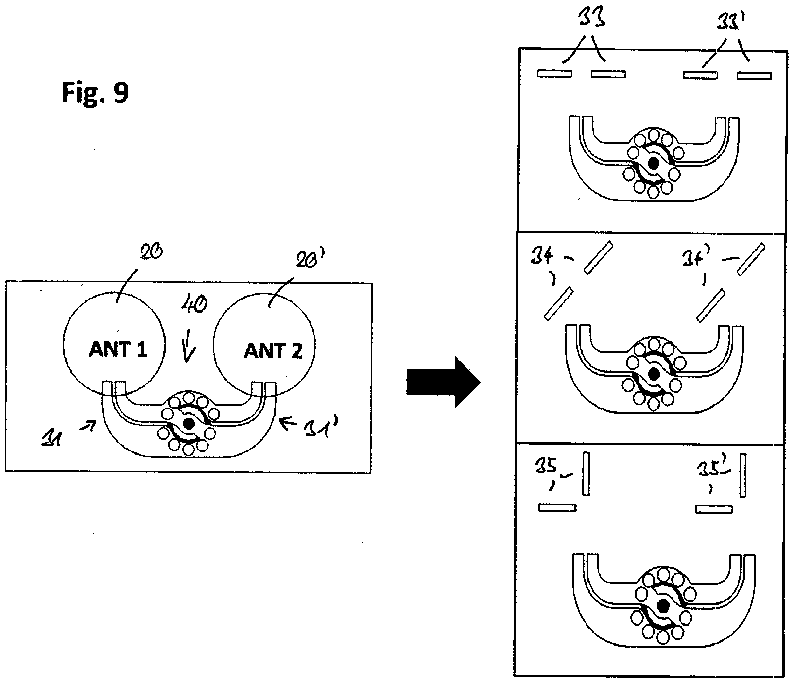

Fig. 9 zeigt noch einmal rechts beispielhaft drei Anordnungen von Dipolhälften beispielhaft einsetzbarer Dipole bei dem Ausführungsbeispiel gemäß Fig. 8a, bei welchem zwei Strahler 20 und 20' über die Anpassungsschaltungen 31 und 31', die hier durch gegensinnige Richtungswechsel der Koplanar-Streifenleitungen gebildet werden, an den Feldwandler angeschlossen sind.

Im obersten Bild rechts sind zwei Strahler 33 und 33' dargestellt, welche als V-Pol oder als H-Pol einsetzbar sind. Bei dem mittleren Ausführungsbeispiel sind zwei Strahler 34 und 34' dargestellt, welche als +45° Pol oder -45° Pol einsetzbar sind. Bei dem unteren Ausführungsbeispiel ist eine Anordnung zweier Strahler 35 und 35' gezeigt, welche ebenfalls als +45° Pol oder -45° Pol einsetzbar sind. Dabei sind jeweils lediglich schematisch die Dipolhälften von Dipolstrahlern dargestellt, ohne die konkrete Anbindung an die Koplanar-Streifenleitungen wiederzugeben.

Gemeinsam ist den Ausführungsbeispielen, dass die Ausrichtung der beiden Antennen, welche über den Leistungsteiler parallel betrieben werden, identisch ist. Insbesondere weisen diese die gleiche Polarisationsebene auf.

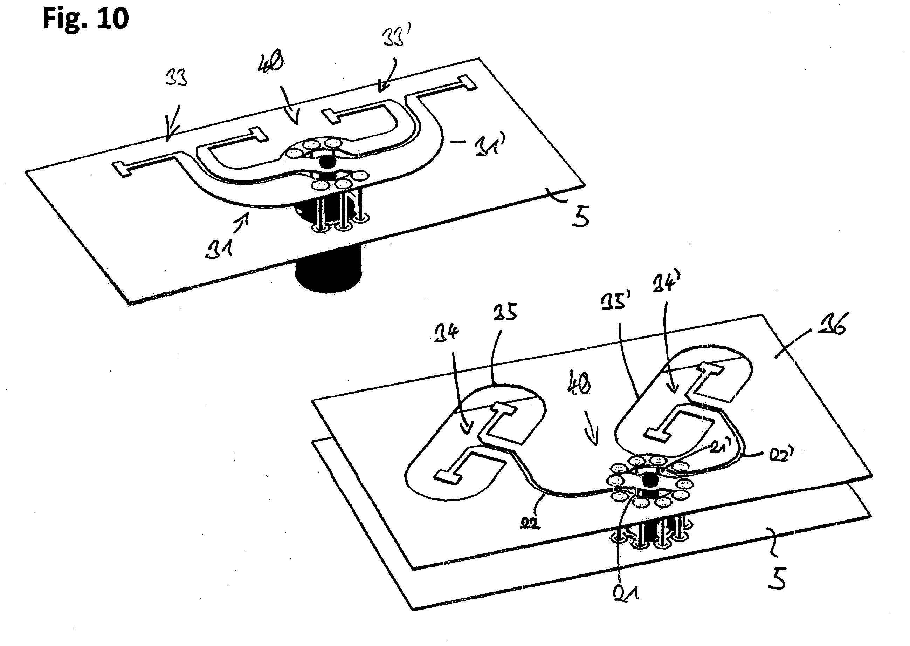

Fig. 10 zeigt ein Ausführungsbeispiel einer Leiterplattenanordnung, bei welcher jeweils sowohl der erste als auch der zweite Aspekt der vorliegenden Erfindung verwirklicht sind. Gemäß dem ersten Aspekt wird jeweils ein Feldwandler 40 eingesetzt, welcher über Koplanar-Streifenleitungen zwei Strahler versorgt. Weiterhin dient gemäß dem zweiten Aspekt die Metallisierungsebene 5 auf der Unterseite des Substrats der Leiterplatte als Reflektor für die durch die auf der Oberseite des Substrats angeordnete Metallisierungsebene gebildeten Strahler 33 und 33', bzw. 34 und 34'.

Bei dem Ausführungsbeispiel oben in Fig. 10 sind zwei Dipolstrahler 33 und 33' eingesetzt, welche jeweils über die als Anpassschaltung 31 und 31' arbeitenden Koplanar-Streifenleitungen mit Signalen von dem Feldwandler 40 versorgt werden.

Bei dem in Fig. 10 unten dargestellten Ausführungsbeispiel sind dagegen zwei Dipol-Schlitzstrahler 34 und 34' vorgesehen, welche ebenfalls über Koplanar-Streifenleitungen mit Signalen von dem Feldwandler 40 versorgt werden. Die beiden Leiterbahnen der Koplanar-Streifenleitungen gehen jedoch hier jeweils in eine zusammenhängende Metallisierungsfläche über, so dass von den Koplanar-Streifenleitungen lediglich der Schlitz 22 bzw. 22' erkennbar ist. Auch die Elemente des Koplanar-Umwandlungsabschnitts des Feldwandlers gehen in die zusammenhängende Metallisierungsfläche über, so dass auch hier lediglich die Schlitze 21 bzw. 21' verbleiben.

Die beiden Dipolelemente der Dipolstrahler 34 und 34' erstrecken sich dabei in einer Aussparung 35 der Metallisierung, so dass zwischen den Dipolelementen und der Metallisierung entsprechende Schlitzabschnitte entstehen.

Bei dem in Fig. 10 oben dargestellten Ausführungsbeispiel erstrecken sich die beiden Strahler in einer gemeinsamen Polarisationsebene. Diese ist gegenüber dem Feldwandler 40 und den Streifenleitungsabschnitten, welche unmittelbar an diesen anschließen, versetzt.

Bei dem Ausführungsbeispiel in Fig. 10 unten erstrecken sich die Strahler dagegen jeweils in parallelen, aber zueinander versetzten Polarisationsebenen. Die Mittelpunkte der beiden Strahler sind jedoch wiederrum in einer Ebene angeordnet, welche gegenüber dem Feldwandler 40 und den Koplanar-Streifenleitungsabschnitten, welche unmittelbar an diesen anschließen, versetzt ist.

Bei den in Fig. 10 dargestellten Ausführungsbeispielen dient die Metallisierungsebene 5 auf der Unterseite des Substrats der Leiterplatte als Reflektor für die Strahler 33 und 33', bzw. 34 und 34'. Hierfür beträgt die Dicke des Substrats zwischen der Metallisierungsebene 5 und der Metallisierungsebene der Strahler bevorzugt ca. λ/4, wobei es sich bei λ um die Wellenlänge im Dielektrikum des Substrats der Mittenfrequenz des untersten Resonanzfrequenzbereichs der Antenne handelt. Erfindungsgemäß erfolgt daher eine gerichtete Abstrahlung der Strahler nur zu einer Seite hin senkrecht zur Ebene der Leiterplatte. Die Metallisierung 5, welche den Reflektor bildet, erstreckt sich daher in der Ebene unterhalb der Strahler 33 bzw. 33' und bildet eine Masseebene.

In den in Fig. 10 dargestellten Ausführungsbeispielen weist die Multilayer-Leiterplatte leiglich zwei Metallisierungsebenen und eine dazwischenliegende Substratschicht auf.

Selbstverständlich ist eine entsprechende Anordnung auch bei einer Multilayer-Leiterplatte mit mehr als zwei Metallisierungsebenen denkbar, so dass beispielsweise die Metallisierungsebene, welche den Reflektor bildet, oder die Metallisierungsebene, in welcher der Strahler oder die Strahler gebildet sind, eine innere Metallisierungsebene der Leiterplatte darstellt.

Weiterhin kann der integrierte Reflektor gemäß dem zweiten Aspekt auch unabhängig von der Anwendung des ersten Aspektes eingesetzt werden, d.h. es kann auf den Feldwandler 40 auch verzichtet werden.

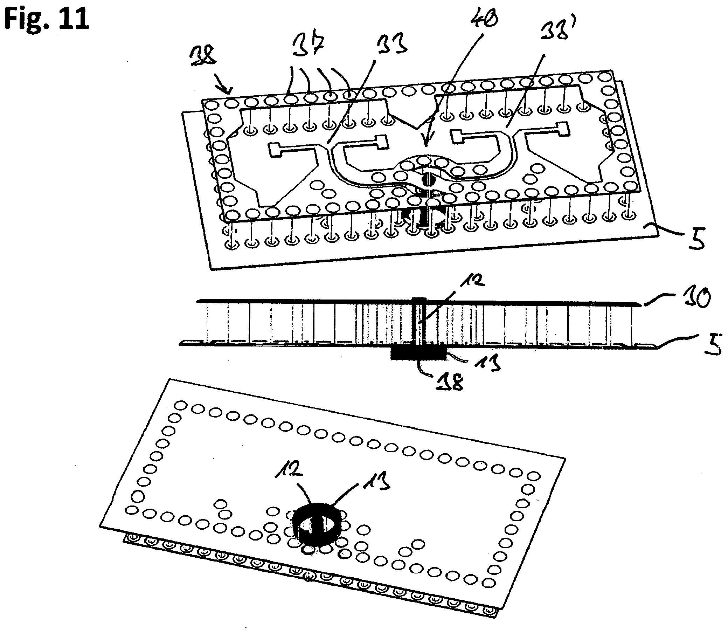

Fig. 11 zeigt ein weiteres konkretes Ausführungsbeispiel einer Leiterplattenantenne, welche sowohl den ersten, als auch den zweiten Aspekt verwirklicht. Die Ausgestaltung der Strahler und des Reflektors entspricht dabei dem Ausführungsbeispiel in Fig. 10 oben. Zusätzlich ist hier jedoch ein Rahmen 38 aus Vias 37 vorgesehen. Die Vias 37 erstrecken sich von der Reflektorebene 5 zur Ebene der Metallisierung, in welcher die Strahler gebildet sind. Die Vias 37 sind weiterhin durch einen rahmenförmigen Metallisierungsabschnitt in dieser Ebene miteinander verbunden. Alternativ könnte der Rahmen 38 aus Vias 37 in einer anderen Ebene unter oder über der Metallisierungsebene, in welcher die Strahler gebildet sind, enden und/oder in einer anderen Ebene unter oder über der Reflektorebene 5 beginnen. Alternativ oder zusätzlich könnte der rahmenförmige Metallisierungsabschnitt in einer anderen Metallisierungsebene als jener, in welcher die Strahler gebildet sind, angeordnet sein, insbesondere in einer Metallisierungsebene über und/oder in niedrigem Abstand zu der Metallisierungsebene, in welcher die Strahler gebildet sind. Die Vias 37 und der rahmenförmige Metallisierungsabschnitt haben ebenfalls Einfluss auf das Antennendiagramm und die S-Parameter und können daher z.B. zum Formen des Fernfelds verwendet werden.

Bei dem in Fig. 11 dargestellten Ausführungsbeispiel dient der Feldwandler 40 wiederrum dem Anschluss eines Koaxialkabels. Hierfür ist der Innenleiter des Koaxial-Leitungsabschnittes 12 als Hohlstab aufgeführt, in welchem der Innenleiter eines Koaxialkabels eingeführt werden kann. Weiterhin ist eine Buchse 13 vorgesehen, welche mit dem Außenleiter eines Koaxialkabels kontaktiert werden kann. Eine solche Kontaktierung ist auch bei den anderen Ausführungsbeispielen der vorliegenden Erfindung möglich.

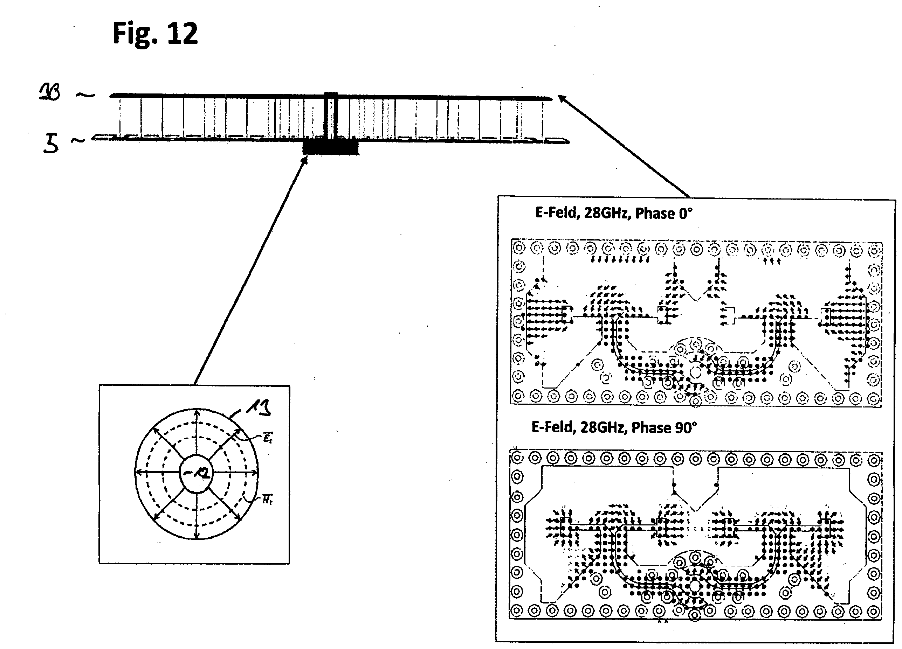

Fig. 12 zeigt das in Fig. 11 dargestellte Ausführungsbeispiel mit der E-Feld Verteilung im Bereich des Koaxial-Leitungsabschnittes sowie im Bereich des Koplanar-Umwandlungsabschnittes des Feldwandlers. In dem Kästchen links unten ist das Koaxialfeld, welches über das Koaxialkabel zugeführt wird, dargestellt. In dem Kästchen rechts ist jeweils das E-Feld des Koplanar-Umwandlungsabschnittes bei Phase 0° und 90° dargestellt. Deutlich zu erkennen ist dabei die Umwandlung von dem radial verlaufenden Koaxialfeld in die Koplanar-Streifenleitungsfelder durch den Koplanar-Umwandlungsabschnitt.

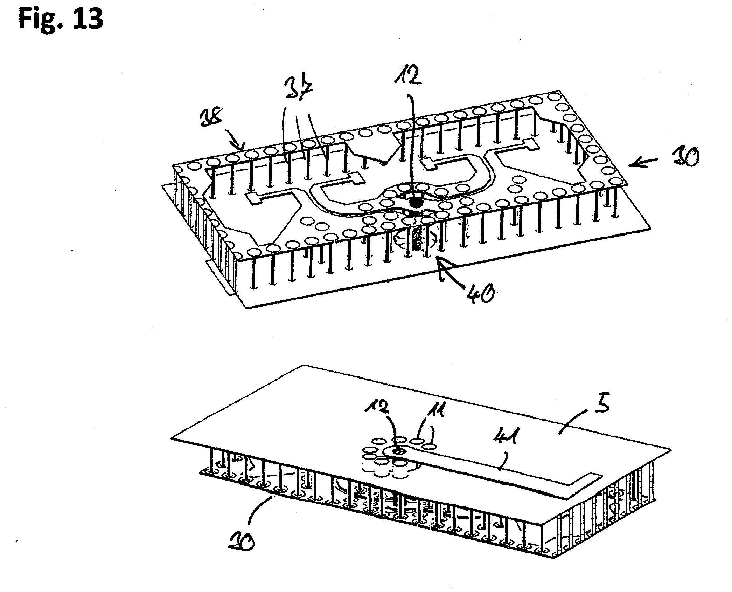

Fig. 13 zeigt ein weiteres Ausführungsbeispiel einer Leiterplattenanordnung, bei welchem beide Aspekte der vorliegenden Erfindung in Kombination verwirklicht sind. Das Ausführungsbeispiel entspricht dabei im Hinblick auf die Strahler, den Rahmen und die Feldwandler dem Ausführungsbeispiel in Fig. 11.

Bei dem in Fig. 13 dargestellten Ausführungsbeispiel dient der Feldwandler jedoch der Signalübertragung innerhalb der Leiterplatte, d.h. von einer ersten Ebene der Leiterplatte zu einer zweiten oder dritten Ebene der Leiterplatte. Insbesondere ist in einer Metallisierungsebene 45 der Leiterplatte eine Streifenleitung 41 angeordnet, wobei der Feldwandler die Signale durch mindestens eine Schicht der Leiterplatte hindurch zur Metallisierungsebene 30, in welcher die Strahler angeordnet sind, führt.

Zwischen diesen beiden Metallisierungsebenen ist im Ausführungsbeispiel die als Reflektor dienende Metallisierungsebene 5 vorgesehen. Dies erlaubt es, die Streifenleitung 41 in der Metallisierungsebene 45 der Leiterplatte unabhängig von der Position der Strahler in der Metallisierungsebene 30 zu führen.

Im Ausführungsbeispiel ist sowohl der Innenleiter, als auch der Außenleiter des Koaxial-Leitungsabschnittes des Feldwandlers 40 durch Vias 11 gebildet. Die Vias 11 verlaufen dabei von der Metallisierungsebene 45 der Streifenleitung 41 zu der dazwischen liegenden Metallisierungsebene 5 und von dort zur Metallisierungsebene 30 der Strahler.

Im Ausführungsbeispiel ist die Streifenleitung 41 als eine Mikrostreifenleitung ausgebildet, und an den Innenleiter 12 des Koaxial-Leitungsabschnittes gekoppelt. Die Metallisierungsebene 5 dient gleichzeitig als Masseebene für die Mikrostreifenleitung 41. Die Vias 11 umgeben den Innenleiter halbkreisförmig, so dass die Streifenleitung 41 auf der offenen Seite aus dem Bereich des Außenleiters herausgeführt werden kann.

Alternativ könnte auch in der Metallisierungsebene 45 eine Koplanar-Streifenleitung eingesetzt werden, um die Signale zum Feldwandler zu führen. In diesem Fall könnte in der Metallisierungsebene 45 ein Koplanar-Umwandlungsabschnitt eingesetzt werden, wie er beispielsweise in Fig. 2 dargestellt ist.

Der in Fig. 13 dargestellte Aufbau erfordert drei Metallisierungsebenen der Multilayer-Leiterplatte, zwischen welchen dielektrische Substratschichten angeordnet sind. Die Substratschichten können, wie im Ausführungsbeispiel gezeigt, eine unterschiedliche Dicke aufweisen. Insbesondere kann die Substratschicht auf der den Strahlern abgewandten Seite der Masseebene 5 dünner sein als die Substratschicht auf der den Strahlern zugewandten Seite, durch welche der Abstand zwischen Strahlern und Reflektor definiert wird.

Weiterhin sind auch Anordnungen denkbar, bei welchen noch mehr Metallisierungsebenen vorgesehen sind. Alternativ oder zusätzlich könnte auf der von den Strahlern abgewandten Seite der Reflektorebene 5, auf welcher auch die Streifenleitung 41 vorgesehen ist, ein Verteilungsnetzwerk, Anpassschaltungen, Elektronickomponenten wie z.B. ein Verstärker, etc. vorgesehen sein.

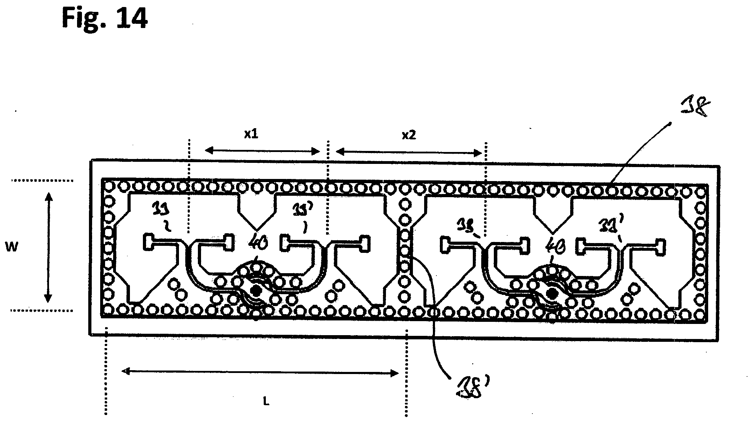

Fig. 14 zeigt ein auf dem in Fig. 13 dargestellten Ausführungsbeispiel basierendes weiteres Ausführungsbeispiel, bei welchem zwei Antennenpaare, wie sie in Fig. 13 gezeugt sind, nebeneinander zu einem Antennenarray zusammengeschaltet sind. Dabei sind zwei Strahlerpaare, wie sie in Fig. 13 dargestellt sind, in einer Reihe nebeneinander angeordnet, so dass die Mittelpunkte sämtlicher Strahler auf einer Linie liegen. Die beiden Strahlenpaare sind jeweils durch Rahmen 38 umgeben, so dass zwischen den beiden Strahlerpaaren eine Rahmenlinie 38' vorgesehen ist.

Der Abstand x1 der beiden Strahler 33 und 33' eines Strahlerpaares, welche gemeinsam über einen als Leistungsteiler arbeitenden Feldwandler 40 versorgt werden, beträgt bevorzugt zwischen 0,5λ und 0,9λ, beispielsweise 0,7λ. Der Abstand x2 zwischen benachbarten Strahlern zweier Strahlerpaare beträgt bevorzugt zwischen 0,5 und 0,9λ, beispielsweise ca. 0,8λ. Die Bereite W des Rahmens senkrecht zur Ausrichtung der Reihe der Strahler beträgt zwischen 0,4λ und 0,8λ, bevorzugt ca. 0,6λ. Die Länge L des Rahmens in Reihenrichtung für ein Strahlerpaar beträgt zwischen 1,2λ und 1,8λ, bevorzugt ca. 1,5λ. Bei λ handelt es sich wiederrum um die Wellenlänge der Mittenfrequenz des untersten Resonanzfrequenzbereiches der Strahler.

Die erfindungsgemäße Leiterplattenantenne wird bevorzugt im Bereich zwischen 3GHz und 300GHz, beispielsweise in einem Frequenzband bei 28GHz, betrieben. Hierdurch ergeben sich extrem kompakte Abmessungen, welche den Einbau einer solchen Gruppenantenne auch in Mobiltelefonen ermöglichen. Die Gruppenantenne kann jedoch auch in Mobilfunk-Basisstationen eingesetzt werden. In diesem Fall werden die Antennen bevorzugt sowohl in Reihen, als auch in Spalten nebeneinander angeordnet.

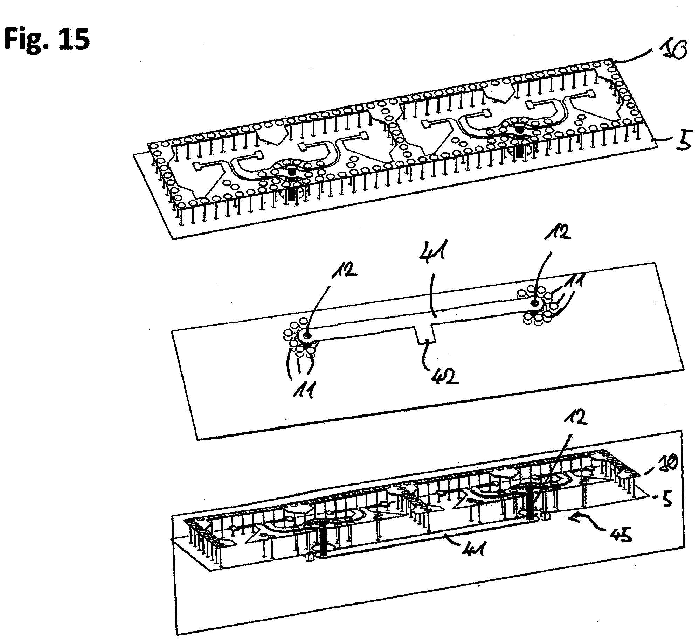

Fig. 15 zeigt das in Fig. 14 dargestellte Ausführungsbeispiel einer Gruppenantenne in einer perspektivischen Ansicht von schräg oben, schräg unten sowie in einer Schnittansicht. Dabei sind die Streifenleitungen 41 zu erkennen, welche die beiden Feldwandler 40 der beiden Strahlerpaare mit Signalen versorgen. Weiterhin ist eine Zuleitung 42 vorgesehen, welche über einen Leistungsteiler in die Zuleitungen 41 übergeht. Hierdurch können sämtliche Strahler parallel betrieben werden. Alternativ wäre es auch denkbar, die einzelnen Strahlerpaare separat mit Signalen zu versorgen und hierfür separate Signalleitungen vorzusehen.

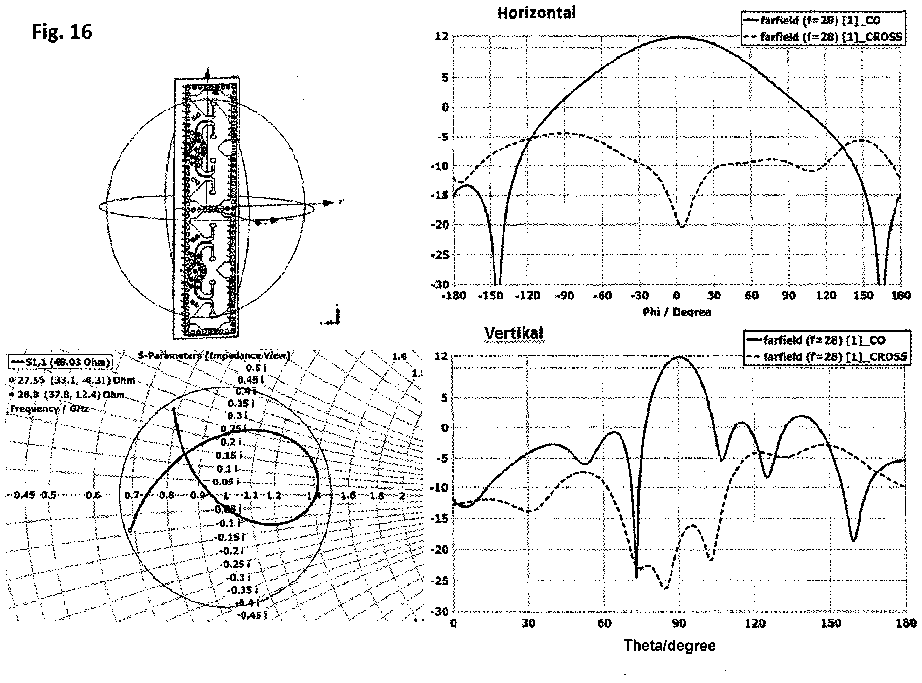

Fig. 16 zeigt nun links den Smith-Chart des in Fig. 14 und 15 dargestellten Antennenarrays, sowie rechts das Fernfeld-Diagramm in einer horizontalen und in einer vertikalen Ebene. Durch die Anordnung der 4 Strahler als eine Spalten-Antenne ergibt sich in vertikaler Ebene eine geringe Halbwertsbreite der Hauptkeule als in horizontaler Ebene.

Durch den in die Leiterplatte integrierten Reflektor wird die Strahlung nur zu einer Seite des Leiterplattenstrahlers hin abgestrahlt. Der in die Leiterplatte integrierte Reflektorrahmen dient der Formung des Fernfeldes.

## Patentansprüche

1. Leiterplattenanordnung mit einer Leiterplatte, deren Metallisierung mindestens zwei Koplanar-Streifenleitungen (1, 1') zur elektrischen Anbindung jeweils eines symmetrisch gespeisten differentiellen Strahlers (20, 20'), insbesondere eines Mobilfunk-Strahlers, umfasst, wobei die mindestens zwei Koplanar-Streifenleitungen (1, 1') aus jeweils zwei voneinander getrennten Leitungsbahnen gebildet sind,
wobei die Leiterplatte einen Feldwandler (6) aufweist, wobei der Feldwandler (6) einen Leistungsteiler (40, 40') zur elektrischen Anbindung der zwei Strahler (20, 20') an eine Signalleitung bildet, wobei der Feldwandler (6) elektrisch mit beiden Koplanar-Streifenleitungen in Verbindung steht,
wobei der Feldwandler (40, 40') ausgebildet ist, ein Koaxial-Feld durch mindestens eine Schicht (2) der Leiterplatte hindurch zu führen und in die koplanaren, differentiellen Streifenleitungsfelder der beiden Koplanar-Streifenleitungen (1, 1') umzuwandeln und aufzuteilen,
**dadurch gekennzeichnet, dass** der Feldwandler (40) ausgebildet ist, das Koaxial-Feld in zwei gegenphasige koplanare Streifenleitungsfelder umzuwandeln und aufzuteilen.

2. Leiterplattenanordnung nach Anspruch 1, wobei die Leiterplattenanordnung mindestens zwei Strahler (20, 20') umfasst und die Strahler als Dipolstrahler und/oder Dipol-Schlitz-Strahler ausgebildet sind, deren zwei Dipolarme jeweils mit einer Leitungsbahn einer Koplanar-Streifenleitung in Verbindung stehen.

3. Leiterplattenanordnung nach Anspruch 1 oder 2, wobei die Leiterplattenanordnung mindestens zwei Strahler (20, 20') umfasst und die beiden Strahler (20, 20') parallel zueinander angeordnet sind und so an den Feldwandler (40) angebunden sind, dass sie gleichphasig abstrahlen,
und/oder
wobei die beiden koplanaren Streifenleitungen (31, 31') dazu ausgebildet sind, durch unterschiedliche Richtungswechsel ein gleichphasiges Feld an den Strahlern (20, 20') zu erzeugen,

4. Leiterplattenanordnung nach einem der vorangegangenen Ansprüche, wobei
die Leiterplattenanordnung mindestens zwei Strahler (20, 20') umfasst und
die Strahler (20, 20') durch die Metallisierung der Leiterplatte gebildet sind, wobei bevorzugt die Strahler (20, 20') in der gleicher Ebene der Leiterplatte angeordnet sind wie die Koplanar-Streifenleitung/en (1, 1'), und/oder wobei der Feldwandler (40, 40') Vias und/oder Metallisierungsabschnitte der Leiterplatte umfasst und bevorzugt durch diese gebildet wird.

5. Leiterplattenanordnung nach einem der vorangegangenen Ansprüche, wobei der Feldwandler (40, 40') einen Koaxial-Leitungsabschnitt (11, 12) aufweist, welcher ausgebildet ist, das Koaxial-Feld durch mindestens eine Schicht (2) der Leiterplatte hindurch zu führen, und einen Koplanar-Umwandlungsabschnitt (7,8), wobei der Koaxial-Leitungsabschnitt bevorzugt auf die Ebene des Koplanar-Umwandlungsabschnitts des Feldwandlers geführt ist und/oder mit diesem elektrisch kontaktiert ist, wobei der Koplanar-Umwandlungsabschnitts (7,8) des Feldwandlers bevorzugt durch Metallisierungsabschnitte der Leiterplatte gebildet ist, und/oder wobei die Leiterplattenanordnung bevorzugt mehrere Vias umfasst, welche einen Außenleiter (11) des Koaxial-Leitungsabschnitts des Feldwandlers bilden, und/oder wobei bevorzugt der Innenleiter (12) des Koaxial-Leitungsabschnitts durch den Innenleiter eines Koaxialkabels und/oder einen Via gebildet wird.

6. Leiterplattenanordnung nach Anspruch 5, wobei der Koplanar-Umwandlungsabschnitt (7, 8) des Feldwandlers zwei Außenleitungsbahnen (7, 8) aufweist, welche mit dem Außenleiter (11) des Koaxialleitungsabschnitts des Feldwandlers in gegenüberliegenden Bereichen in Verbindung stehen, wobei die beiden Außenleitungsbahnen (7, 8) in jeweils mindestens eine Bahn (23, 24) einer Koplanar-Streifenleitung (1) übergehen.

7. Leiterplattenanordnung nach Anspruch 6, wobei die Leiterplatte zwei Koplanar-Streifenleitungen (1, 1') aufweist, mit welchen der Koplanar-Umwandlungsabschnitt (7, 8) des Feldwandlers auf entgegengesetzten Seiten in Verbindung steht, wobei die Außenleitungsbahnen (7, 8) des Feldwandler bevorzugt in mindestens eine Bahn (23, 24, 23', 24') der jeweiligen Koplanar-Streifenleitung (1, 1') übergehen,
wobei bevorzugt
der Koplanar-Umwandlungsabschnitt des Feldwandlers eine Diagonalbahn (19) aufweist, welche gegenüberliegende Bahnen (23, 24') der beiden Koplanar-Streifenleitungen (1, 1') diagonal miteinander verbindet und bevorzugt mit dem Innenleiter (12) eines Koaxialleitungsabschnitts des Feldwandlers in Verbindung steht, wobei die Außenleitungsbahnen (7, 8) bevorzugt auf gegenüberliegenden Seiten ausgebildet sind, kapazitiv oder galvanisch an den Diagonalleitungsabschnitt (19) zu koppeln,
und/oder wobei bevorzugt
die zwei Außenleitungsbahnen (7, 8) jeweils auf beiden Seiten in eine Bahn (23, 24, 23', 24') der jeweiligen Koplanar-Streifenleitungen (1, 1') übergehen, wobei der Innenleiter (12) des Koaxialleitungsabschnitts des Feldwandlers bevorzugt frei bleibt.

8. Leiterplattenanordnung nach Anspruch 6, wobei die Leiterplatte eine Koplanar-Streifenleitung (1) aufweist, welche auf einer Seite mit dem Koplanar-Umwandlungsabschnitt (7,8) des Feldwandlers in Verbindung steht, wobei die beiden Außenleitungsbahnen (7, 8) in jeweils eine Bahn (23, 24) der Koplanar-Streifenleitung übergehen und auf der gegenüberliegenden Seite miteinander in Verbindung stehen, wobei bevorzugt der Koplanar-Umwandlungsabschnitt des Feldwandlers eine Abschlussfläche (10) umfasst, welche einen der Außenleiterabschnitte (7) mit dem Innenleiter (12) verbindet.

9. Leiterplattenanordnung nach einem der vorangegangenen Ansprüche, wobei der Feldwandler zum Anschluss eines Koaxialkabels an die Leiterplatte dient, wobei das Koaxialkabel bevorzugt quer zur Ebene der Leiterplatte und insbesondere senkrecht zur Ebene der Leiterplatte an diese angeschlossen ist, wobei bevorzugt das Koaxial-Feld durch ein Koaxialkabel zum Feldwandler geführt wird, und/oder wobei bevorzugt der Innenleiter (12) des Koaxialkabels den Innenleiter (12) eines Koaxial-Leitungsabschnitts des Feldwandlers bildet oder mit einem solchen elektrisch kontaktiert ist, und/oder wobei bevorzugt der Außenleiter (13) den Außenleiter (11) eines Koaxial-Leitungsabschnitts des Feldwandlers bildet oder mit einem solchen elektrisch kontaktiert ist.

10. Leiterplattenanordnung nach einem der vorangegangenen Ansprüche, wobei es sich bei der Leiterplatte um eine Multi-Layer-Leiterplatte handelt, wobei der Feldwandler zur Signalverbindung zwischen zwei Ebenen der Leiterplatte dient, und/oder wobei die Koplanar-Streifenleitung in einer ersten Metallisierungsebene der Leiterplatte angeordnet ist und die Leiterplatte in einer zweiten oder dritten Metallisierungsebene eine Streifenleitung aufweist, welche über den Feldwandler mit der Koplanar-Streifenleitung durch mindestens eine Schicht (2) der Leiterplatte hindurch elektrisch in Verbindung steht, wobei es sich bei der Streifenleitung insbesondere um eine Mikrostreifenleitung handelt, und/oder wobei der Feldwandler bevorzugt in der ersten Metallisierungsebene der Leiterplatte einen Koplanar-Umwandlungsabschnitt, in der zweiten oder dritten Metallisierungsebene der Leiterplatte einen Streifenleitungsabschnitt, und einen Koaxial-Leitungsabschnitt aufweist, welcher den Koplanar-Umwandlungsabschnitt durch mindestens eine Schicht der Leiterplatte hindurch mit dem Streifenleitungsabschnitt verbindet, wobei bevorzugt die Leiterplatte eine zweite Metallisierungsebene (5) umfasst, die zwischen der dritten Metallisierungsebene des Koplanar-Umwandlungsabschnitts und der ersten Metallisierungsebene des Streifenleitungsabschnitts angeordnet ist, welche bevorzugt als Masseebene dient.

11. Leiterplattenanordnung nach einem der vorangegangenen Ansprüche, mit einer Leiterplatte, deren Metallisierung in mindestens einer ersten Metallisierungsebene einen Strahler (33, 33'), insbesondere einen Mobilfunk-Strahler, umfasst, wobei der Reflektor (5) des Strahlers (33, 33') durch eine zweite Metallisierungsebene der Leiterplatte gebildet wird, wobei die zweite Metallisierungsebene bevorzugt einen Abstand zwischen 0,1 λ und 0,7 λ zur ersten Metallisierungsebene hat.

12. Leiterplattenanordnung nach Anspruch 11, wobei der Strahler (33, 33') durch eine Streifenleitung (41) versorgt wird, welche in einer dritten Metallisierungsebene der Leiterplatte verläuft, wobei die den Reflektor bildende zweite Metallisierungsebene (5) zwischen der die Streifenleitung bildenden dritten Metallisierungsebene und der ersten Metallisierungsebene des Strahlers verläuft, und/oder wobei der Strahler (33, 33') und die Streifenleitung (41) durch eine Schicht (5) der Leiterplatte hindurch mittels des Feldwandlers elektrisch in Verbindung stehen, wobei der Feldwandler bevorzugt ausgebildet ist, ein Koaxial-Feld durch mindestens eine Schicht der Leiterplatte hindurch zu führen, und/oder wobei die Metallisierung der Leiterplatte mindestens eine Koplanar-Streifenleitung zur Signalversorgung des Strahlers umfasst.

13. Leiterplattenanordnung nach einem der vorangegangenen Ansprüche, wobei die Leiterplattenanordnung mindestens einen Strahler (20, 20') umfasst, und wobei der Strahler oder die Strahler von einem Rahmen (38) umgeben ist oder sind, welcher durch Vias (37) gebildet ist, und/oder wobei der Strahler oder die Strahler als Dipol-Strahler und/oder Dipol-Schlitz-Strahler ausgeführt sind, und/oder wobei eine Mehrzahl von Strahlern in Form eines Arrays auf der Leiterplatte angeordnet sind.

14. Leiterplattenanordnung nach einem der vorangegangenen Ansprüche, wobei die Leiterplattenanordnung mindestens einen Strahler (20, 20') umfasst, und
wobei
der Strahler oder die Strahler einen Resonanzfrequenzbereich und/oder eine Mittenfrequenz eines Resonanzfrequenzbereichs aufweisen, welcher in einem Frequenzbereich zwischen 3 GHz und 300 GHz liegt, bevorzugt in einem Frequenzbereich zwischen 20 GHz und 60 GHz.

15. Mobilfunkgerät, insbesondere Mobilfunk-Basisstation, Mobilfunk-Repeater oder Mobilfunkendgerät, mit einer Leiterplattenanordnung nach einem der vorangegangenen Ansprüche.

## Claims

1. Circuit board assembly comprising a circuit board, the metallization of which comprises at least two coplanar striplines (1, 1') for electrically connecting one symmetrically supplied differential radiator (20, 20') each, wherein the at least two coplanar striplines (1, 1') are each formed of two conductor tracks separated from each other,
wherein the circuit board comprises a field converter (6), the field converter (6) forming a power divider (40, 40') for electrically connecting the two radiators (20, 20') to a signal line, the field converter (6) being electrically connected to the at least two coplanar striplines,
wherein the field converter (40, 40') is designed to conduct a coaxial field through at least one layer (2) of the circuit board and convert and divide the coaxial field into the coplanar, differential stripline fields of the two coplanar striplines (1, 1'),
**characterized in that**
the field converter (40) is designed to convert and divide the coaxial field into two anti-phase coplanar stripline fields.

2. The circuit board assembly according to Claim 1, wherein the circuit board assembly comprises at least two radiators (20, 20') and the radiators are designed as dipole radiators and/or dipole slot radiators, the two dipole arms of which are connected to a coplanar stripline.

3. The circuit board assembly according to Claim 1 or 2,
wherein the circuit board assembly comprises at least two radiators (20, 20') and the two radiators (20, 20') are arranged parallel to each other and connected to the field converter (40) such that they radiate in phase,
and/or
wherein the two coplanar striplines (31, 31') are designed to generate an in-phase field at the radiators (20, 20') by means of different changes of direction.

4. The circuit board assembly according to any one of the previous claims, wherein the circuit board assembly comprises at least two radiators (20, 20') and the radiators (20, 20') are formed by the metallization of the circuit board, wherein the radiators (20, 20') are preferably arranged in the same plane of the circuit board as the coplanar stripline/s (1, 1'), and/or wherein the field converter (40, 40') comprises vias and/or metallization sections of the circuit board and is preferably formed thereby.

5. The circuit board assembly according to any one of the previous claims, wherein the field converter (40, 40') comprises a coaxial line section (11, 12) that is designed to guide the coaxial field through at least one layer (2) of the circuit board, and a coplanar conversion section (7, 8), wherein the coaxial line section is preferably routed onto the plane of the coplanar conversion section of the field converter and/or is electrically contacted therewith, wherein the coplanar conversion section (7, 8) of the field converter is preferably formed by metallization sections of the circuit board, and/or wherein the circuit board assembly preferably comprises a plurality of vias, which form an outer conductor (11) of the coaxial line section of the field converter, and/or wherein the inner conductor (12) of the coaxial line section is formed by the inner conductor of a coaxial cable and/or a via.

6. The circuit board assembly according to claim 5, wherein the coplanar conversion section (7, 8) of the field converter comprises two outer conductor paths (7, 8) which are connected to the outer conductor (11) of the coaxial line section of the field converter in opposite regions, the two outer conductor paths (7, 8) merging into at least one respective path (23, 24) of a coplanar stripline (1).

7. The circuit board assembly according to claim 6, wherein the circuit board has two coplanar striplines (1, 1') to which the coplanar conversion section (7, 8) of the field converter is connected on opposite sides, the outer conductor paths (7, 8) of the field converter merging into at least one path (23, 24, 23', 24') of the respective coplanar stripline (1, 1'),
wherein preferably
the coplanar conversion section of the field converter comprises a diagonal path (19), which diagonally connects opposite paths (23, 24') of the two coplanar striplines (1, 1') and which is preferably connected to the inner conductor (12) of a coaxial line section of the field converter, the outer conductor paths (7, 8) preferably being formed to couple to the diagonal path section (19) on opposite sides capacitively or galvanically,
and/or wherein preferably
the two outer conductor paths (7, 8) each merge on both sides into a path (23, 24, 23', 24') of the respective coplanar striplines (1, 1'), the inner conductor (12) of the coaxial line section of the field converter preferably remaining free.

8. The circuit board assembly according to claim 6, wherein the circuit board comprises a coplanar stripline (1) connected on one side to the coplanar conversion section (7, 8) of the field converter, wherein the two outer conductor paths (7, 8) merge into a respective path (23, 24) of the coplanar stripline and are connected to one another on the opposite side, wherein the coplanar conversion section of the field converter comprises an end face (10), which connects one of the outer conductor sections (7) to the inner conductor (12).

9. The circuit board assembly according to any one of the previous claims, wherein the field converter serves to connect a coaxial cable to the circuit board, wherein the coaxial cable is preferably connected to the circuit board transversely to the plane of the circuit board and in particular to the plane of the circuit board, wherein the coaxial field is preferably conducted to the field converter through a coaxial cable, and/or wherein the inner conductor (12) of the coaxial cable preferably forms the inner conductor (12) of a coaxial line section of the field converter or is in electrical contact therewith, and/or wherein the outer conductor (13) preferably forms the outer conductor (11) of a coaxial line section of the field converter or is in electrical contact therewith.

10. The circuit board assembly according to any one of the previous claims, wherein the circuit board is a multilayer circuit board, wherein the field converter is used for establishing a signal connection between two planes of the circuit board, and/or wherein the coplanar stripline is arranged in a first metallization plane of the circuit board and the circuit board comprises in a second or third metallization plane a stripline, which is electrically connected to the coplanar stripline via the field converter through at least one layer (2) of the circuit board, wherein the stripline is in particular a microstripline and/or wherein the field converter preferably comprises a coplanar conversion section in the first metallization plane of the circuit board, a stripline section in the second or third metallization plane of the circuit board, and a coaxial line section connecting the coplanar conversion section through at least one layer of the circuit board to the stripline section, wherein the circuit board preferably comprises a second metallization plane (5), arranged between the third metallization plane of the coplanar conversion section and the first metallization plane of the stripline section, which acts as a ground plane.

11. The circuit board assembly according to any one of the previous claims, having a circuit board, the metallization of which in at least one first metallization plane has an radiator (33, 33'), in particular a mobile radio radiator, wherein the reflector (5) of the radiator (33, 33') is formed by a second metallization plane of the circuit board, wherein the second metallization plane is preferably at a distance of between 0.1λ and 0.7λ from the first metallization plane.

12. The circuit board assembly according to claim 11, wherein the radiator (33, 33') is supplied by a stripline (41) extending in a third metallization plane of the circuit board, wherein the second metallization plane (5) forming the reflector extends between the third metallization plane forming the stripline and the first metallization plane of the radiator, and/or wherein the radiator (33, 33') and the stripline (41) are electrically connected by means of the field converter through a layer (5) of the circuit board, wherein the field converter is preferably designed to conduct a coaxial field through at least one layer of the circuit board, and/or wherein the metallization of the circuit board comprises at least one coplanar stripline for supplying signals to the radiator.

13. The circuit board assembly according to any one of the previous claims, wherein the circuit board assembly comprises at least one radiator (20, 20') and wherein
the radiator or radiators is/are surrounded by a frame (38), which is defined by vias (37), and/or wherein the radiator or radiators is/are configured as dipole radiators and/or as dipole slot radiators, and/or wherein a plurality of radiators are arranged on the circuit board in the form of an array.

14. The circuit board arrangement according to any one of the previous claims, wherein the circuit board assembly comprises at least one radiator (20, 20'), and wherein
the radiator or radiators has/have a resonant frequency range and/or a centre frequency of a resonant frequency range which is in a frequency range between 3 GHz and 300 GHz, preferably in a frequency range between 20 GHz and 60 GHz.

15. Mobile radio device, in particular a mobile radio base station, a mobile radio repeater, or a mobile radio terminal, comprising a circuit board assembly according to any one of the previous claims.

## Revendications

1. Agencement de plaquette de circuit imprimé comportant une plaquette de circuit imprimé, dont la métallisation comprend au moins deux lignes ruban coplanaires (1, 1') pour la connexion électrique d'un radiateur différentiel alimenté symétriquement (20, 20'), notamment un radiateur de radiotéléphonie mobile, dans lequel les au moins deux lignes à ruban coplanaires (1, 1') sont formées respectivement de deux pistes conductrices séparées l'une de l'autre, dans lequel la plaquette de circuit imprimé présente un convertisseur de champ (6), dans lequel le convertisseur de champ (6) forme un diviseur de puissance (40, 40') pour la connexion électrique des deux radiateurs (20, 20') à une ligne de signal, dans lequel le convertisseur de champ (6) est électriquement connecté aux deux lignes ruban coplanaires, dans lequel le convertisseur de champ (40, 40') est conçu pour guider un champ coaxial à travers au moins une couche (2) de la plaquette de circuit imprimé et pour convertir et diviser dans les champs de lignes ruban différentielles coplanaires des deux lignes ruban coplanaires (1, 1'), **caractérisé en ce que en ce que** le convertisseur de champ (40) est conçu pour convertir et diviser le champ coaxial en deux champs de lignes ruban coplanaires en opposition de phase.

2. Agencement de plaquette de circuit imprimé selon la revendication 1, dans lequel l'agencement de plaquette de circuit imprimé comprend au moins deux radiateurs (20, 20') et les radiateurs sont conçus en tant que radiateurs dipôles et/ou des radiateurs à fentes dipolaires, dont les deux bras dipolaires sont respectivement connectés à un chemin de ligne d'une ligne ruban coplanaire.

3. Agencement de plaquette de circuit imprimé selon la revendication 1 ou 2, dans lequel l'agencement de plaquette de circuit imprimé comprend au moins deux radiateurs (20, 20') et les deux radiateurs (20, 20') sont disposés parallèlement l'un à l'autre et sont reliés au convertisseur de champ (40) de manière à rayonner en phase, et/ou dans lequel les deux lignes ruban coplanaires (31, 31') sont conçues à cet effet afin de générer un champ en phase au plan des radiateurs (20, 20') par un changement de direction différent.

4. Agencement de plaquette de circuit imprimé selon une quelconque des revendications précédentes, dans lequel l'agencement de plaquette de circuit imprimé comprend au moins deux radiateurs (20, 20') et les radiateurs (20, 20') sont formés par la métallisation de la plaquette de circuit imprimé, dans lequel les radiateurs (20, 20') sont de préférence disposés dans le même plan de la plaquette de circuit imprimé sous la forme de lignes ruban coplanaires (1, 1'), et/ou dans lequel le convertisseur de champ (40, 40') comprend des traversées et/ou des sections de métallisation de la plaquette de circuit imprimé et est de préférence formé par celles-ci.

5. Agencement de plaquette de circuit imprimé selon une des revendications précédentes, dans lequel le convertisseur de champ (40, 40') présente une section de ligne coaxiale (11, 12), qui est conçue pour guider le champ coaxial à travers au moins une couche (2) de la plaquette de circuit imprimé et une section de conversion coplanaire (7, 8), dans lequel la section de ligne coaxiale est de préférence guidée au plan de la section de conversion coplanaire du convertisseur de champ et/ou est électriquement en contact avec elle, dans lequel la section de conversion coplanaire (7,8) du convertisseur de champ est de préférence formée par des sections métallisées de la plaquette de circuit imprimé, et/ou dans lequel l'ensemble de plaquette de circuit imprimé comprend de préférence plusieurs traversées, qui forment un conducteur extérieur (11) de section de ligne coaxiale du convertisseur de champ, et/ou dans lequel le conducteur intérieur (12) de la section de ligne coaxiale est de préférence formé par le conducteur intérieur d'un câble coaxial et/ou une traversée.

6. Agencement de plaquette de circuit imprimé selon la revendication 5, dans lequel la section de conversion coplanaire (7, 8) du convertisseur de champ comporte deux pistes conductrices extérieures (7, 8), qui sont connectées au conducteur extérieur (11) de la section de ligne coaxiale du convertisseur de champ dans des zones opposées, dans lequel les deux pistes conductrices extérieures (7, 8) se rejoignent respectivement en au moins une piste (23, 24) d'une ligne ruban coplanaire (1).

7. Agencement de plaquette de circuit imprimé selon la revendication 6, dans lequel la plaquette de circuit imprimé présente deux lignes à ruban coplanaires (1, 1'), avec lesquelles la section de conversion coplanaire (7, 8) du convertisseur de champ communique sur des côtés opposés, dans lequel les pistes conductrices extérieures (7, 8) du transducteur de champ sont de préférence fusionnées en au moins une piste (23, 24 23', 24') de la ligne ruban coplanaire respective (1, 1'), dans lequel de préférence la section de conversion coplanaire du convertisseur de champ présente une piste diagonale (19), qui relie des pistes opposées (23, 24') des deux lignes ruban coplanaires (1, 1') en diagonale l'une à l'autre et est de préférence reliée au conducteur intérieur (12) d'une section de ligne coaxiale du convertisseur de champ, dans lequel les conducteurs de ligne extérieurs (7, 8) sont formés de préférence sur des côtés opposés, pour coupler de manière capacitive ou galvanique à la section de ligne diagonale (19) et/ou dans lequel de préférence les deux pistes conductrices extérieures (7, 8) aboutissent respectivement à une piste (23, 24, 23', 24') des lignes ruban coplanaires respectives (1, 1'), dans lequel le conducteur intérieur (12) de la section de ligne coaxiale du convertisseur de champ reste de préférence libre.

8. Agencement de plaquette de circuit imprimé selon la revendication 6, dans lequel la plaquette de circuit imprimé comporte une ligne ruban coplanaire (1) qui est connectée d'un côté à la section de conversion coplanaire (7, 8) du transducteur de champ, dans lequel les deux pistes conductrices extérieures (7, 8) aboutissent respectivement à une piste (23, 24) de la ligne ruban coplanaire et sont reliées l'une à l'autre sur des côtés opposés, dans lequel la section de conversion coplanaire du convertisseur de champ comprend de préférence une surface d'extrémité (10) qui relie une des sections de conducteur extérieurs (7) au conducteur intérieur (12).

9. Agencement de plaquette de circuit imprimé selon une quelconque des revendications précédentes, dans lequel le convertisseur de champ sert à connecter un câble coaxial à la plaquette de circuit imprimé, dans lequel le câble coaxial est de préférence connecté à la plaquette de circuit imprimé transversalement au plan de la plaquette de circuit imprimé et en particulier perpendiculairement au plan de la plaquette de circuit imprimé, dans lequel le champ coaxial est de préférence guidé vers le convertisseur de champ par l'intermédiaire d'un câble coaxial, et/ou de préférence le conducteur intérieur (12) du câble coaxial forme le conducteur intérieur (12) d'une section de ligne coaxiale du convertisseur de champ ou est en contact électrique avec celui-ci, et /ou le conducteur extérieur (13) forme de préférence le conducteur extérieur (11) d'une section de ligne coaxiale du convertisseur de champ ou est en contact électrique avec celle-ci.

10. Agencement de plaquette de circuit imprimé selon une des revendications précédentes, dans lequel la plaquette de circuit imprimé est une plaquette de circuit imprimé multicouche, dans lequel le convertisseur de champ est utilisé pour la connexion de signal entre deux plans de la plaquette de circuit imprimé, et/ou dans lequel la ligne ruban coplanaire est disposée dans un premier plan de métallisation de la plaquette de circuit imprimé et la plaquette de circuit imprimé présente une ligne ruban dans un deuxième ou un troisième plan de métallisation, qui est connectée électriquement via le convertisseur de champ à la ligne ruban coplanaire par au moins une couche (2) de la plaquette de circuit imprimé, dans lequel la ligne ruban est notamment une ligne microruban et/ou dans lequel le convertisseur de champ présente de préférence une section de conversion coplanaire dans le premier plan de métallisation de la plaquette de circuit imprimé, dans le deuxième ou la troisième plan de métallisation de la plaquette de circuit imprimé une section de ligne ruban, et une section de ligne coaxiale, qui relie la section de conversion coplanaire à la section de ligne micro ruban à travers au moins une couche de la plaquette de circuit imprimé, dans lequel la plaquette de circuit imprimé comprend de préférence un deuxième plan de métallisation (5) qui est situé entre le troisième plan de métallisation de la section de conversion coplanaire et le premier plan de métallisation de la section de ligne ruban, qui sert de préférence de plan de masse.

11. Agencement de plaquette de circuit imprimé selon une des revendications précédentes, comportant une plaquette de circuit imprimé ,dont la métallisation comporte un radiateur (33, 33'), notamment un radiateur radio mobile, dans lequel le réflecteur (5) du radiateur (33, 33') est formé par un deuxième plan de métallisation de la plaquette de circuit imprimé, dans lequel le deuxième plan de métallisation comporte de préférence un écart compris entre 0,1λ et 0,7λ par rapport au premier plan de métallisation.

12. Agencement de plaquette de circuit imprimé selon la revendication 11, dans lequel le radiateur (33, 33') est alimenté par une ligne ruban (41), qui s'étend dans un troisième plan de métallisation de la plaquette de circuit imprimé, dans lequel le deuxième plan de métallisation (5) formant le réflecteur s'étend entre le deuxième plan de métallisation (5) formant le troisième plan de métallisation de la ligne ruban et le premier plan de métallisation du radiateur et/ou dans lequel le radiateur (33, 33') et la ligne ruban (41) sont reliés électriquement à travers une couche (5) de la plaquette de circuit imprimé au moyen du convertisseur de champ, dans lequel le convertisseur de champ est de préférence formé pour guider un champ coaxial à travers au moins une couche de la plaquette de circuit imprimé, et/ou dans lequel la métallisation de la plaquette de circuit imprimé comprend au moins une ligne ruban coplanaire pour l'alimentation du signal du radiateur.

13. Agencement de plaquette de circuit imprimé selon une des revendications précédentes, dans lequel l'agencement de plaquette de circuit imprimé comprend au moins un radiateur (20, 20'), et dans lequel le ou les radiateurs est ou sont entouré(s) d'un cadre (38) qui est formé par des traversées (37) et/ou le ou les radiateurs sont réalisés sous forme de radiateurs dipôles et/ou de radiateurs à fentes dipolaires, et/ou dans lequel une pluralité de radiateurs sont agencés sous la forme d'une matrice sur la plaquette de circuit imprimé.

14. Agencement de plaquette de circuit imprimé selon une des revendications précédentes, dans lequel l'agencement de plaquette de circuit imprimé comprend au moins un radiateur (20, 20'), et dans lequel le ou les radiateurs présentent une plage de fréquences de résonance et/ou une fréquence centrale d'une plage de fréquences de résonance qui se situe dans une plage de fréquences entre 3 GHz et 300 GHz, de préférence dans une plage de fréquences entre 20 GHz et 60 GHz.

15. Appareil radio mobile, en particulier station de base radio mobile, répéteur radio mobile ou terminal radio mobile, comportant un agencement de plaquette de circuit imprimé selon une des revendications précédentes.
